(19) Europäisches Patentamt

European Patent Office

Office européen des brevets

(11) **EP 0 688 092 B1**

(12) **EUROPEAN PATENT SPECIFICATION**

(45) Date of publication and mention
of the grant of the patent:
**24.10.2001 Bulletin 2001/43**

(51) Int Cl.[7]: **H02M 5/00**

(21) Application number: **95109045.5**

(22) Date of filing: **12.06.1995**

(54) **Inverter apparatus**

Wechselrichteranordnung

Dispositif onduleur

(84) Designated Contracting States:
**DE FR**

(30) Priority: **16.06.1994 JP 13450294**
**08.09.1994 JP 21480894**
**19.09.1994 JP 22343394**

(43) Date of publication of application:
**20.12.1995 Bulletin 1995/51**

(73) Proprietor: **Hitachi, Ltd.**
**Chiyoda-ku, Tokyo 101 (JP)**

(72) Inventors:
• **Sugino, Hidenori**
**Sakura-shi (JP)**

• **Ishii, Akiko, Hitachi Izumiryo 207**
**Funabashi-shi (JP)**
• **Suzuki, Norinaga**
**Funabashi-shi (JP)**
• **Muramatsu, Masaharu**
**Wakaba-ku, Chiba-shi (JP)**
• **Endo, Tsunehiro**
**1070-5, Mimomicho-1-chome,**
**Narashino-shi (JP)**

(74) Representative: **Strehl Schübel-Hopf & Partner**
**Maximilianstrasse 54**
**80538 München (DE)**

(56) References cited:
**GB-A- 2 271 679          US-A- 4 908 738**

## Description

BACKGROUND OF THE INVENTION

The present invention relates to an inverter apparatus for converting an AC power of a given frequency to an AC power of another given frequency.

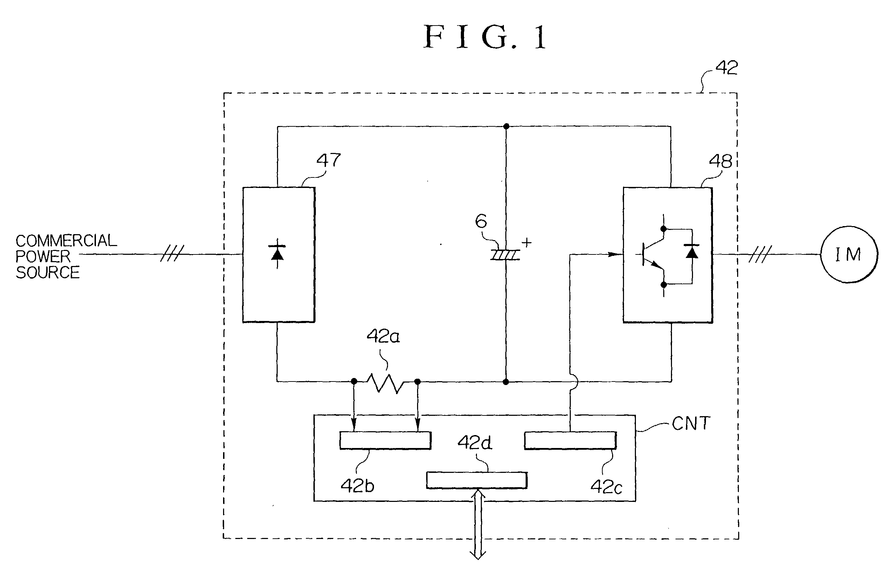

In recent years, the inverter apparatus is widely employed because of capability of driving a general-purpose induction motor at variable speeds with high efficiency in a simplified manner. In general, the inverter apparatus is implemented in such an internal structure as illustrated in Fig. 1 of the accompanying drawings.

More specifically, Fig. 1 shows in a circuit diagram major components required for basic operation of the inverter apparatus in general. In the figure, the inverter apparatus as a whole is designated by a reference numeral 42. Further, in this figure, reference character 47 denotes a forward conversion circuit, 48 denotes a backward or reverse conversion circuit, 6 denotes a smoothing electrolytic capacitor, CNT designates an inverter control circuit, 42a designates a main circuit direct current detecting resistor, 42b designates a main circuit direct current detector, 42c designates an output frequency command circuit, 42d designates an external interface circuit, and a symbol IM designates an induction motor.

The inverter apparatus mentioned above is supplied with a three-phase AC power from a commercial AC line of e.g. 50 Hz or 60 Hz, wherein a DC power is derived from the three-phase AC power through the forward conversion circuit 47 and smoothed by the capacitor C. The smoothed DC power is again converted to an AC power by the reverse conversion circuit 48. With this arrangement, the AC power of a given or desired frequency in a range of a low frequency of e.g. 0.5 Hz to a high frequency of e.g. 1000 Hz can be supplied to the induction motor IM which constitutes a load, to thereby drive the induction motor IM at a speed which can be varied over a wide range, as desired.

In the inverter apparatus described above, there is provided at the input side of the forward conversion circuit 47 a main circuit input terminal board which is equipped with terminals for connecting the forward conversion circuit 47 to the commercial power source system, while provided at the output side of the reverse conversion circuit 48 is a main circuit output terminal board equipped with terminals for interconnecting the reverse conversion circuit 48 and the load such as the induction motor IM.

Parenthetically, in the inverter apparatus known heretofore, the forward conversion circuit, the reverse conversion circuit and the main circuit terminal boards are separately or individually incorporated in the inverter apparatus, wherein the forward conversion circuit, the reverse conversion circuit and the main circuit terminal boards are interconnected by using electric wires and/or wiring substrate, as is disclosed in, for example, Japanese Patent Application laid-open No. JP-A-60-219968. However, in the prior art inverter apparatus, it is noted that substantially no consideration is paid concerning the disposition of the internal circuits or devices such as those mentioned above, presenting a problem which can never be neglected from the standpoint of "miniaturization of apparatus" which is increasingly demanded in many fields of applications. In other words, the inverter apparatus known heretofore is severely limited in respect to the uses or applications where miniaturization of the apparatus is prerequisite.

A similar inverter apparatus comprising the subject matter of the preamble of claim 1 is disclosed in GB 227 1679.

More specifically, in the case of the prior art inverter apparatus, the forward conversion circuit and the reverse conversion circuit are implemented as separate devices or units, respectively. Additionally, the main circuit terminals are also disposed individually. Besides, in many cases, the main circuit terminal board is soldered to a circuit substrate or mounted on a frame, a casing or the like of the apparatus.

Such being the circumstances, in the prior art inverter apparatus, the space required for disposition of the forward conversion circuit, the reverse conversion circuit and additionally for disposition of the terminal boards as well as the space required for laying down electric wires among them increase unavoidably, providing a great obstacle to miniaturization of the inverter apparatus.

Furthermore, it is imperative to supply a sufficiently smoothed DC voltage to the input of the reverse conversion circuit 48, which in turn means that a capacitor having a considerably large electrostatic capacity has to be provided in the DC main circuit. For this reason, as the main circuit electrolytic capacitor 6, there is usually employed an electrolytic capacitor, which however occupies a considerably large space in the inverter apparatus. By way of example, in the case of the conventional inverter apparatus such as described in JP-A-60-219968, the smoothing electrolytic capacitor for the main circuit is previously provided with appropriate mounting member for securing the capacitor or alternatively it is fixedly secured interiorly of the inverter apparatus by using a frame and screws, wherein for making the electrical connection to the electrolytic capacitor, terminals of the latter are directly connected to conductor patterns of a wiring substrate by soldering. Alternatively conductor bars or electric wires are soldered to the electrolytic capacitor for allowing it to be subsequently electrically connected to a destined circuit by way of the conductor bars and/or electric wires. It is however noted that in the case of the prior art inverter apparatus, no consideration is paid to the fact that the electrolytic capacitor is an element having a predetermined use life, which thus involves a problem when the electrolytic capacitor has to be exchanged upon lapse of the use life thereof.

More specifically, exchange of the main circuit electrolytic capacitor in the prior art inverter apparatus usually requires procedures mentioned below.

(I) In the case where the main circuit electrolytic capacitor is soldered to a substrate:

①A frame is detached from a main body of the inverter apparatus by removing screws.
② A substrate is dismounted from the main body or die-cast member by detaching screws, whereupon connectors, electric wires and others mounted on the substrate are removed to allow the substrate having the electrolytic capacitor to be taken out from the inverter apparatus.
③The electrolytic capacitor is then detached by fusing away the solder to be subsequently exchanged with a fresh electrolytic capacitor, which is then connected by soldering.
④The connectors, the electric wires and other are again connected to the substrate, which is then fixedly mounted on the main body by screws, whereupon the frame is mounted.

In the procedure mentioned above, attention must be paid in the soldering step ③ such that through-holes and patterns formed in the substrate are protected against injury.
(II) In the case where the main circuit electrolytic capacitor is mounted on a frame by screws:

①The frame and the substrate are dismounted from the main body by removing the screws and others.
② Molded bars or electric wire and others mounted on the electrode(s) of the electrolytic capacitor are detached, whereon the electrolytic capacitor is dismounted to be replaced by a new one.
③The main body is assembled to the starting or original state.

The electrolytic capacitor for the main circuit occupies a large proportion of the volume of the inverter apparatus. Thus, in the prior art inverter apparatus, the mounting structure for the electrolytic capacitor is disadvantageous when considering the electrolytic capacitor exchanging procedures mentioned above, presenting thus a great obstacle to an attempt for miniaturization as well as reduction of manufacturing cost.
Further, in the inverter apparatus in which switching elements such as transistors are employed, the power conversion processing requires indispensably switching operations, incurring generation of relatively lots of noises, which may exert adverse influences to a variety of electric control devices as well as home-use destined apparatuses disposed in the vicinity of the inverter apparatus.

Such being the circumstances, when the inverter apparatuses is used, a noise elimination filter is employed for reducing the noises, as occasion requires.
In this conjunction, it is noted that the noise elimination filter and the inverter apparatus are provided as separate units which thus have to be interconnected or alternatively the noise elimination filter is incorporated in the inverter apparatus as an integral part thereof to thereby constitute a filter build-in type inverter apparatus.
However, in the hitherto known inverter apparatuses, no consideration is paid to limitation imposed on the inverter apparatus by the provision of the noise elimination filter as well as limitation imposed on reduction of the manufacturing cost in the case where the filter built-in type inverter apparatus is of concern.
More specifically, in the prior art inverter apparatus in which an independent or discrete noise elimination filter is employed, some especial measures have to be taken upon mounting of the filter so that noise eliminating function can not be affected. To say in another way, in order to allow the noise attenuation characteristics of the filter to be fully exhibited, it is required to dispose the inverter apparatus and the noise elimination filter sufficiently close to each other with electrical connection path between the inverter apparatus and the filter being shortened to a possible minimum. Additionally, input and output conductors of the noise elimination filter will have to be so disposed that they are distanced from each other to a possible maximum. Besides, there may arise such a problem that the wiring for grounding the noise elimination filter and the inverter apparatus to the earth becomes troublesome because those portions of the filter and the inverter apparatus which are to be connected to the ground potential have to be separated from each other. Moreover, there also arises such a problem that the noise eliminating function of the filter becomes degraded although it depends on the manner in which the grounding wire is laid down. In reality, however, realization of the optimal dispositions of the noise elimination filter and the inverter apparatus as well as electric interconnection with shortest path therebetween encounters a great difficulty because of restriction imposed on the available mounting or accommodating space and differences in shape and dimension between the inverter apparatus and the noise elimination filter or from the stand point of assembling procedure. For these reasons, it has been very difficult to miniaturize the inverter apparatus with the noise eliminating function being taken into account.
On the other hand, the prior art inverter apparatus which incorporates therein the noise elimination filter as an integral part thereof is also disadvantageous and unprofitable in that when the inverter apparatus is installed for the applications where the noise eliminating function is not required, the filter circuit will then become unnecessary, which degrades the cost performance of the inverter apparatus, not to say of the fact that the inverter apparatus is implemented unnecessarily in a large size.

## SUMMARY OF THE INVENTION

In the light of the state of the art described above, it is an object of the present invention to provide an inverter apparatus which can be manufactured in a sufficiently miniaturized size with significantly low cost and which can be implemented substantially as a general-purpose type inverter apparatus.

In view of the above and other objects which will become apparent as the description proceeds, it is proposed according to a general aspect of the present invention that the forward conversion circuit and the reverse conversion circuit which constitute main circuits of the inverter apparatus as well as the terminal boards, inclusive of interconnecting wires thereamong, are integrally implemented in a module structure.

Because the forward conversion circuit and the reverse conversion circuit as well as the terminal boards are implemented in a module and thus need not be mounted individually, not only the spaces otherwise required for mounting the components mentioned above separately but also wirings for electrical connections among them can be spared. Besides, space required for carrying out wiring work is rendered unnecessary. Thus, high miniaturization of the inverter apparatus can be achieved.

Furthermore, because wires and/or conductor substrate for interconnecting the terminal boards, the forward conversion circuit and the reverse conversion circuit can be spared, the number of assembling steps can be decreased, which provides a great contribution to reduction of manufacturing cost of the inverter apparatus.

In an inverter apparatus according to a preferred embodiment of the invention, not only the inverter apparatus can be miniaturized but also the capacitor can easily be exchanged without need for a number of steps, a lot of time and skill. Additionally, the number of steps involved in manufacturing and assembling the inverter apparatus can remarkably be decreased, which naturally leads to significant reduction of the manufacturing cost.

In a preferred mode for carrying out the invention, a frame structure of a shallow box-like shape may be provided as a part of a case of the inverter apparatus, wherein a capacitor accommodating chamber is provided, into which a capacitor can removably be inserted. Further, connecting terminals capable of being resiliently mounted and removed (e.g. snap terminals) are provided as connecting terminals for the electrode terminals of the capacitor.

The mounting or removal of the capacitor to or from the inverter apparatus can be accomplished simply by inserting or withdrawing the capacitor into or from the capacitor accommodating chamber. Further, owing to the connecting terminals capable of being resiliently mounted or detached, electrical path to the electrode terminal of the capacitor can be formed or disconnected simply by inserting or pulling out the connecting terminal.

Thus, the structure for accommodating the capacitor in the inverter apparatus can be miniaturized. Besides, the exchange of the capacitor is much facilitated such that no skill therefor is essentially required. Additionally, the number of steps involved in assembling the inverter apparatus can remarkably be decreased, which of course contributes to a great reduction of the manufacturing cost.

In another preferred mode for carrying out the invention, miniaturization of the inverter apparatus can be achieved even in the case where a noise elimination is to be satisfactorily realized by the filter regardless of conditions under which the inverter apparatus is installed. In that case, the inverter apparatus can equally be operated without noise eliminating function.

In yet another preferred mode for carrying out the invention, the forward conversion circuit, the reverse conversion circuit, a terminal board for a power source and a terminal board for a load such as an induction motor are integrally implemented in an inverter unit or module, which is then disposed together with a noise elimination filter on one surface of a cooling fin unit which also serves as a supporting base, wherein connecting wires between a terminal board of the noise elimination filter and at least one of the terminal board for the power source and the terminal board for the load are disposed in a local region on the aforementioned one surface of the cooling fin unit.

By virtue of the structure described above, the inverter module implemented independent of the cooling fin unit serving as the base allows the use of the cooling fin unit having a size which can be selected rather arbitrarily.

Since the noise elimination filter is mounted on the cooling fin unit, the whole structure can be handled as a unit. Besides, wiring for electric connection can be performed only on the one surface of the cooling fin unit.

Thus, the distance between the inverter unit or module and the noise elimination filter can be shortened to a minimum regardless of the conditions under which the inverter apparatus is installed, which in turn means that the length of the interconnecting wire can be shortened correspondingly. Furthermore, owing to the shielding effect provided by the cooling fin unit, the filter function can satisfactorily be exhibited. Of course, the inverter apparatus inclusive of the noise elimination filter can be implemented in a miniaturized structure.

It should further be added that in the application where noise elimination is not required, the inverter apparatus can be constituted only by the inverter unit and the cooling fin unit, which is profitable from the economical stand point.

BRIEF DESCRIPTION OF THE DRAWINGS

In the course of the following detailed description, reference is made to the attached drawings in which:

Fig. 1 is a schematic circuit diagram showing an exemplary configuration of a main circuit of an inverter apparatus which the present invention is of concern;

Fig. 2 is an exploded perspective view showing an inverter apparatus according to an embodiment of the present invention;

Fig. 3A is a side elevational showing an outer appearance of the inverter apparatus according to the above embodiment of the invention;

Fig. 3B is a top plan view of the same;

Fig. 3C is a view similar to Fig. 3B and shows the same in the state in which a manipulation panel cover is removed;

Fig. 3D is another side elevational view showing the same;

Fig. 4 is a fragmentary perspective view showing a control terminal cover of the inverter apparatus shown in Fig. 2;

Fig. 5A is a top plan view showing a power module according to an embodiment of the invention;

Fig. 5B is an end view of the same;

Fig. 5C is a sectional view of the same taken along a line A-A in Fig. 5A;

Fig. 6 is a circuit diagram showing a circuit configuration of a power module according to another embodiment of the invention;

Fig. 7 is a partially exploded perspective view showing a capacitor box in an inverter apparatus according to yet another embodiment of the invention;

Fig. 8 is a partially exploded perspective view showing a capacitor box in an inverter apparatus according to still another embodiment of the invention;

Fig. 9 is an exploded perspective view showing an inverter apparatus according to a further exemplary embodiment of the present invention;

Fig. 10 is an exploded perspective view showing an inverter apparatus according to a still further embodiment of the present invention;

Fig. 11 is a perspective view showing an outer appearance of one of the inverter apparatuses shown in Figs. 9 and 10;

Fig. 12 is a perspective view showing an outer appearance of the other of the inverter apparatuses shown in Figs. 9 and 10;

Fig. 13A is a top plan view showing a structure of a capacitor box in the inverter apparatus shown in Fig. 9 or 10;

Fig. 13B is a view showing a capacitor stopper member;

Fig. 13C is a perspective view of the capacitor box in the state where capacitors are accommodated;

Fig. 14A, 14B and 14C are circuit diagrams showing, respectively, exemplary configurations of main circuits of the inverter apparatuses of Fig. 9 or 10;

Fig. 15A is a top plan view showing an inverter apparatus including an inverter mounted on a cooling fin unit together with a noise elimination filter according to yet another embodiment of the invention;

Fig. 15B is a side elevational view of the same;

Fig. 15C is an end view of the same;

Fig. 16 is a circuit diagram showing generally a circuit configuration of the inverter apparatus shown in Figs. 15A, 15B and 15C;

Fig. 17A is a top plan view showing an inverter apparatus according to another embodiment of the invention which is directed to a combination of an inverter unit and a noise elimination filter module;

Fig. 17B is a side view of the same;

Fig. 18A is a top plan view showing an inverter apparatus including a combination of an inverter unit and a noise elimination filter module according to yet another embodiment of the invention;

Fig. 18B is a side elevational view of the same;

Fig. 19A is a top plan view showing an inverter apparatus including a combination of an inverter unit and a noise elimination filter module according to still another embodiment of the invention;

Fig. 19B is a side elevational view of the same;

Fig. 19C is a side view of the same;

Fig. 20A is a top plan view showing a structure of an inverter apparatus incorporating a noise elimination filter according to a further embodiment of the invention; and

Fig. 20B is a side elevational view of the same.

DESCRIPTION OF THE PREFERRED EMBODIMENTS

Now, the invention will be described in detail in conjunction with what is currently considered as preferred or exemplary embodiments by referring to the accompanying drawings.

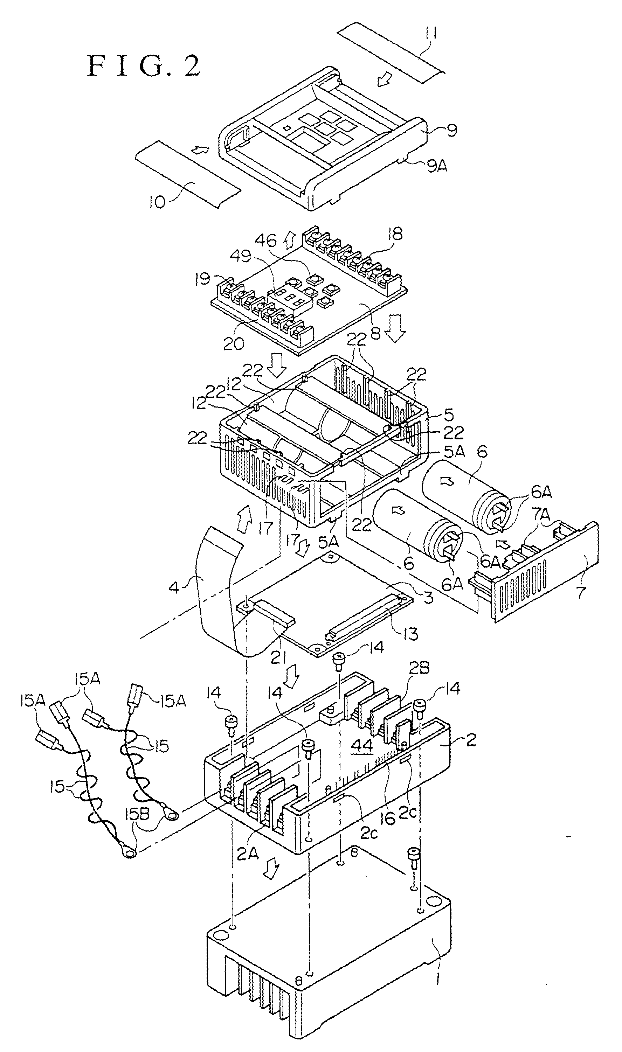

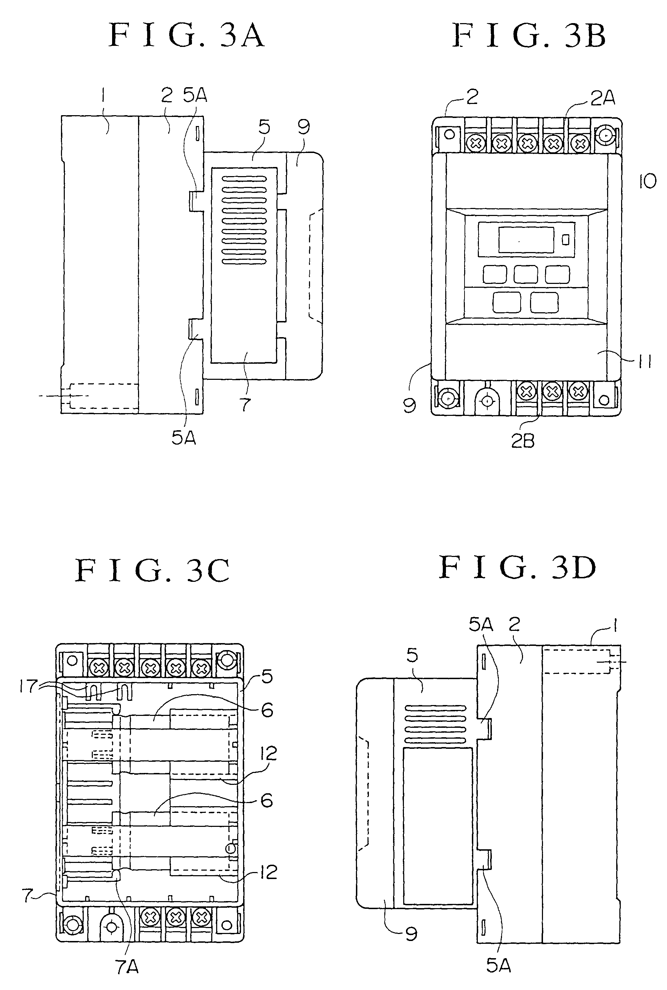

Figures 2 and 3 show an inverter apparatus according to an embodiment of the present invention. Referring to the figures, the inverter apparatus is generally comprised of a cooling fin unit 1 which may be formed of e.g. aluminum by die casting, a power module 2, a power source substrate 3, a flexible flat cable 4, a capacitor box 5, main circuit electrolytic capacitors 6 each having electrode terminals 6A, a control substrate 8, a manipulation panel cover 9, control circuit terminal covers 10 and 11, capacitor accommodating chambers 12 formed in the capacitor box 5, a bottom entry socket 13, screws 14, wires 15 each having a fastened terminal 15A (the terminal adapted to be inserted in place under resiliency) and a crimped terminal 15B (the terminal adapted to be mounted in place by means of screw), a terminal pin block 16 of the power module 2, wire holders 17, control circuit terminal boards 18 and 19, a vertical type socket 20, a horizontal type socket 21, projections 22 for positioning the control substrate 8 to be held, and a digital key array 46.

The cooling fin unit 1 is formed of e.g. aluminum through die casting so as to serve as a supporting base for the inverter apparatus as a whole and is provided with a plurality of cooling fins.

The forward conversion circuit 47 and the reverse conversion circuit 48 described hereinbefore in conjunction with Fig. 1 are incorporated in the power module 2. In this state, the power module 2 is packaged with the input terminal board 2A for the power source and the output terminal board 2B for the load in an integral structure having a same planar shape and dimensions as the cooling fin unit 1 by using a synthetic resin. The power module package thus formed is then stacked on the cooling fin unit 1 and fixedly mounted thereon by using four screws 14.

With the structure described above, heat generated by the forward conversion circuit 47 and the reverse conversion circuit 48 incorporated in the power module 2 is directly transferred to the cooling fin unit 1, whereby cooling function of high efficiency can be realized.

On the other hand, there are packaged or mounted on the power source substrate 3 a drive circuit for driving the reverse conversion circuit 48 and a power source circuit required for the operations of various circuit components. The power source substrate 3 is adapted to be disposed in horizontal orientation within the power module 2 from the above to be accommodated therein. In that case, the terminal pin block 16 of the power module 2 is fitted into the bottom entry socket 13 of the power source substrate 3, whereby electric interconnections are formed between the circuits mounted on the power source substrate 3 and those on the power module 2. In this way, interface as required between the power module 2 and the power source substrate 3 is automatically realized.

As can be seen from Fig. 2 among others, the capacitor box 5 is formed by a preselected synthetic resin material in the form of a shallow box-like frame having a same widthwise dimension as that of the power module 2 and a longitudinal dimension shorter than the widthwise dimension, wherein a pair of capacitor accommodating chambers 12 are formed in juxtaposition to each other internally of a side wall of the capacitor box 5 extending in the widthwise direction, while the wall of the capacitor box 5 located in opposition is opened to form an aperture. The capacitor box cover 7 is adapted to be fitted into this aperture for covering it.

In this conjunction, it should be mentioned that, as can be seen from Fig. 2, the capacitor accommodating chamber 12 is formed in a press-fit structure by making use of a slope at which a die is withdrawn upon die removal, i.e., in a structure that the inner diameter is decreased or tapered in the depthwise direction so that after insertion of the main circuit electrolytic capacitor 6, the latter is further pressed into the capacitor accommodating chamber 12 to be thereby held rigidly at a predetermined position.

More specifically, when the capacitor box cover 7 is fitted under pressure after having placed the main circuit electrolytic capacitors 6 in the capacitor accommodating chambers 12, respectively, the main circuit electrolytic capacitors 6 are further pushed inwardly by projections 7A formed integrally with the capacitor box cover 7 to be thereby held snugly and stationarily at the respective predetermined positions under a sufficiently high friction for preventing the electrolytic capacitors 6 from being inadvertently removed.

The connection of the main circuit electrolytic capacitors 6 to the inverter DC main circuit is realized by connecting the electrode terminals 6A of the electrolytic capacitors 6 inserted in the capacitor box 5 to the DC plus-terminals and the DC minus-terminals, respectively, which are mounted on the input terminal board 2A of the power module 2.

Each of the electric wires 15 is provided with the fastened terminal 15A at one end and the crimped terminal 15B at the other end. Thus, desired electric connection can be formed by first mounting the crimped terminal 15B on the DC terminal of the input terminal board 2A of the power module 2 and then inserting the fastened terminal 15A to the electrode terminal 6A of the main circuit electrolytic capacitor 6.

To this end, a pair of DC terminals mounted on the input terminal board 2A of the power module 2 are connected to a P-line of plus polarity and an N-line of minus polarity of the DC output circuit, i.e., the inverter DC main circuit internally of the power module 2.

Thus, in the inverter apparatus according to the instant embodiment of the invention, the procedure for mounting the electrolytic capacitor 6 can be much simplified. More specifically, the electrolytic capacitor 6 can be mounted even after having assembled the capacitor box 5. Besides, it is unnecessary to disassemble the main body upon exchange of the electrolytic capacitor 6. To this end, it is sufficient to remove the capacitor box cover 7, pull out the fastened terminals 15A of the wires 15 and withdraw the electrolytic capacitor 6 for exchange with a new one.

Furthermore, it should be mentioned that the wire holders 17 are provided on the inner side of a left-hand side wall as viewed in Fig. 2 (or at a top wall as viewed in Fig. 3C) of the capacitor box 5, wherein the electric wires 15 are held with intermediate portions thereof being wound around the wire holders 17 in such a manner that the electric wires 15 are protected against breakage and short-circuit fault due to unwanted physical or mechanical contact.

On the other hand, the capacitor box 5 is provided with four claws 5A, while the power module 2 is formed with corresponding recesses 2C.

Thus, with the structure of the inverter apparatus according to the instant embodiment of the invention, the mounting of the capacitor box 5 onto the power module 2 can be accomplished simply by stacking the capacitor box 5 onto the power module 2 under pressure.

The flexible flat cable 4 serves for making connection between the power source substrate 3 and the control substrate 8. To this end, the power source substrate 3 is provided with the horizontal socket 21 while the control substrate 8 is provided with the vertical socket 20 at a rear sided thereof, wherein by inserting both end portions of the flexible flat cable 4 into the vertical socket 20 and the horizontal socket 21, respectively, interface as required can be established between the power source substrate 3 and the control substrate 8.

Packaged on the control substrate 8 are an element such as a microcomputer required for controlling of the inverter, control circuit terminal boards 18 and 19 and additionally a digital manipulation key array 46 and a display device 49.

Parenthetically, it should be mentioned that in the case of the inverter apparatus according to the instant embodiment of the invention, the control substrate 8 is accommodated within the capacitor box 5 at a top portion thereof. For this reason, the flexible flat cable 4 extends in a loop form roundabout the main circuit electrolytic capacitors 6 placed within the capacitor box 5. However, it should be appreciated that various other connecting methods can be adopted by changing the dispositions of the electrolytic capacitor 6, the power source substrate 3 and/or the control substrate 8.

For mounting the control substrate 8, the latter is held by the projections 22 provided internally of the capacitor box 5, whereupon the manipulation panel cover 9 is mounted from the above to thereby fixedly secure the control substrate 8 onto the capacitor box 5. In this conjunction, the mounting of the manipulation panel cover 9 onto the capacitor box 5 can be accomplished by fitting claw members 9A into corresponding slots.

Figure 3A is a side elevational showing an outer appearance of the inverter apparatus according to the instant embodiment of the invention, Fig. 3B is a top plan view of the same, Fig. 3C is a view similar to Fig. 3B and shows the same in the state in which the manipulation panel cover 9 is removed, and Fig. 3D is another side elevational view showing the same.

As can be seen from these figures, the power module 2 is fixedly stacked on the cooling fin unit 1. Thus, heat generated in the inverter main circuits including the forward conversion circuit 47, the reverse conversion circuit 48 and other is transferred to the cooling fin unit 1 by way of a metal substrate on which the circuits mentioned above are mounted to be thereby dissipated to the ambient air from the cooling fin unit 1. In this way, the cooling function as required can be realized.

Further, since the capacitor box 5 and the manipulation panel cover 9 are stacked sequentially in this order at the top side of the power module 2, i.e., in opposition to the cooling fin unit 1, the inverter apparatus assumes in general an outer appearance similar to that of a general-purpose electromagnetic switch with the input terminal board 2A being disposed at one end (upper end) while the output terminal board 2B is disposed at the opposite end (lower end).

Thus, when various commands such as a frequency command are inputted to the inverter apparatus from a predetermined external device connected to the control circuit terminal boards 18 and 19 or alternative by operator by manipulating the digital key array 46 after connection of the electric wires extending from the three-phase AC power source to R-, S- and T-terminals of the input terminal board 2A and connection of the wires extending from the induction motor IM to U-, V- and W-terminals of the output terminal board 2B, the corresponding command signals are fetched by the microcomputer mentioned hereinbefore, whereby inverter drive signals are newly generated by the microcomputer in dependence on the input signals to be transmitted to the power source substrate 3 by way of the flexible flat cable 4 and ultimately to the power module 2 for controlling the inverter. In this manner, the induction motor IM can be driven at a desired speed which is of course variable.

Further, at the same time, various signals from the power module 2 is transmitted to the control substrate 8 from the power source substrate 3 via the flexible flat cable 4 and fetched by the microcomputer to be utilized in carrying out various processings as required.

As will now be appreciated from the foregoing description, the number of screws required for assembling the inverter apparatus can be decreased to only four screws for mounting the power module. The succeeding mounting of the capacitor box 5 and the manipulation panel cover 9 can be achieved by stacking them sequentially and engaging the claw members in the associated recesses, respectively. Thus, the mounting procedure can be much facilitated with the number of assembling steps as involved being decreased.

Provided at both ends of the manipulation panel cover 9 are the terminal boards 18 and 19 of the control substrate 8, in correspondence to which there are provided the control circuit terminal covers 10 and 11 of a structure capable of being opened and closed in the manipulation panel cover 9, as can be seen in Figs. 2 and 3. Accordingly, when the control circuit terminal boards 18 and 19 are not used, faults such as occurrence of short-circuit, contact failure and others due to invasion of dust and the like can positively be prevented by closing the covers mentioned above.

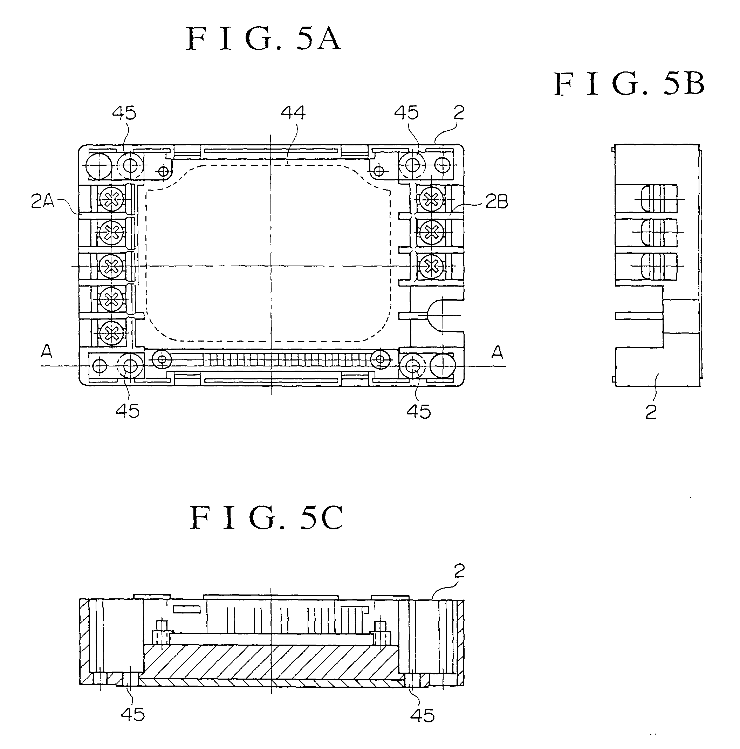

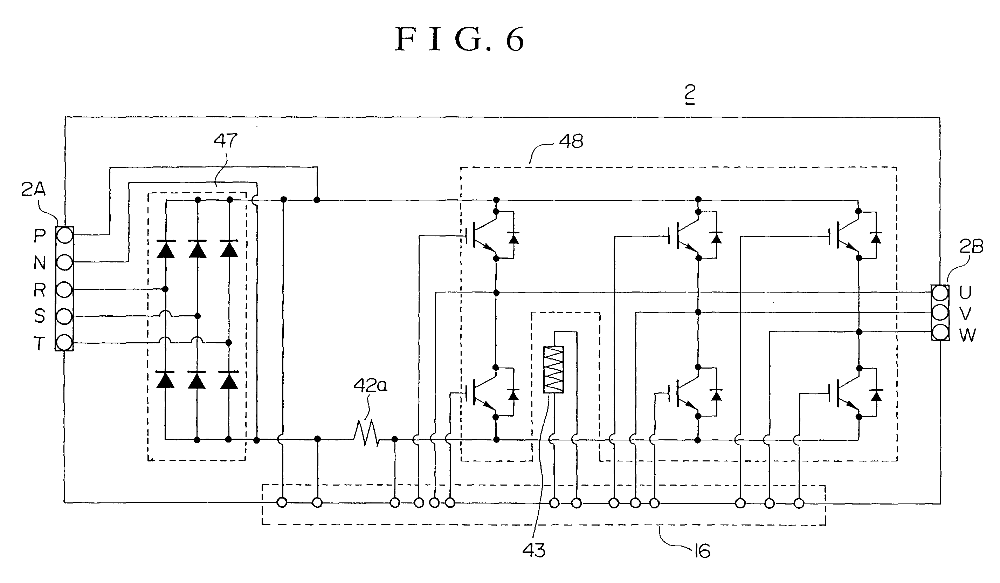

Figures 5A, 5B and 5C show an embodiment of the power module 2. As can be seen from a circuit diagram of Fig. 6, the power module 2 according to the instant embodiment of the invention is comprised of the forward conversion circuit 47, the reverse conversion circuit 48, the input terminal board 2A, the output terminal board 2B, a temperature detecting element 43 such as a thermistor element or the like for detecting the temperature of the reverse conversion circuit 48, the terminal pin block 16 for making interface with the drive circuit for driving the reverse conversion circuit and the power source circuit, and a main circuit direct current detecting resistor 42a, wherein all the components except for the input terminal board 2A and the output terminal board 2B are mounted on the metal substrate in a same plane and packaged in an integral structure by a preselected synthetic resin after wiring in a pattern corresponding to the connections shown in Fig. 6.

The forward conversion circuit 47 is implemented in the form of a three-phase bridge rectifier circuit which is comprised of six diodes connected in a bridge form. The DC output of the forward conversion circuit 47 is connected to the reverse conversion circuit 48 via a main circuit DC bus.

The input terminal board 2A is provided with five terminals including power receiving input terminals R, S and T and DC voltage terminals P and N, wherein the power input terminals R, S and T are connected to AC input points, respectively, which are provided, respectively, by three diode series connections of the three-phase bridge rectifier circuit constituting the forward conversion circuit 47. Connected to the power input terminals R, S and T is a commercial three-phase AC power source of 50 Hz, 60 Hz or other frequency.

On the other hand, the DC voltage terminals P and N of the input terminal board 2A are connected to the main circuit DC bus which is supplied with a DC power outputted from the forward conversion circuit 47, wherein capacitors disposed externally of the power module 2 are connected to the DC voltage terminals P and N for smoothing the DC voltage, as described hereinafter.

The reverse conversion circuit 48 has six arms each including an insulated gate bipolar transmitter (IGBT) and a fly-wheel diode connected in antiparallel to each other. The reverse conversion circuit 48 is implemented in the form of a three-phase inverter circuit by interconnecting the above-mentioned six arms in a bridge circuit between the plus (P) line and the minus (N) line of the main circuit DC bus, wherein the three arm serial connections define the three-phase AC output points, respectively.

The output terminal board 2B is provided with three AC output terminals U, V and W which are connected to three-phase AC output points of the reverse conversion circuit 48, respectively, wherein the induction motor IM constituting a load of the inverter apparatus is connected to these AC output terminals U, V and W.

The main circuit direct current detecting resistor 42a is provided for the purpose of converting the current flowing through the N-line of the main circuit DC bus into a voltage which is to be extracted externally, while the temperature detecting element 43 is adapted for detecting the temperature of the IGBT (Insulated Gate Bipolar Transistor) element incorporated in the reverse conversion circuit 48 to thereby obtain a signal which is utilized for protecting the IGBT element against thermal destruction.

The terminal pin block 16 serves as a circuit interfacing module to which wires for inputting a gate drive signal for the IGBTs of the power module 2 and taking out the main circuit DC voltage signals and the main circuit direct current value detected internally of the power module 2 as well as the temperature detection signal of the reverse conversion circuit 48 from the power module 2.

Now, turning back to Fig. 5, the structure of the power module 2 will be elucidated in detail.

In the inverter apparatus according to the instant embodiment of the invention, the power module 2 is made of a synthetic resin generally in the form of an elongated coverless rectangular box of a shallow depth, wherein the input terminal board 2A and the output terminal board 2B are symmetrically disposed at opposite ends of the box as viewed in the longitudinal direction thereof in the integral structure of the power module 2, as can be seen in Fig. 5. Formed in the bottom wall of the box-like power module 2 at corner portions thereof are through-holes 45 for mounting the cooling fin unit 1, as described later on.

At this juncture, it should be mentioned that the inverter apparatus according to the instant embodiment of the invention is primarily contemplated to be mounted in a vertical orientation on a wall of a building with the input terminal board 2A being located atop while the output terminal board 2B is positioned at the bottom.

The power module 2 is manufactured in the manner described below.

The elements or components constituting the main circuits such as the forward conversion circuit 47, the reverse conversion circuit 48, the temperature detecting element 43 for the reverse conversion circuit and the main circuit direct current detecting resistor 42a are mounted on a metal substrate. More specifically, the metal substrate is formed substantially in a rectangular shape, wherein the forward conversion circuit 47 and others mentioned above are mounted on one surface of the metal substrate. Subsequently, the input terminal board 2A, the output terminal board 2B and terminal members constituting the individual terminals of the terminal pin block 16 are prepared and wires are laid among the terminal members and the individual elements constituting the main circuits mentioned above in such a manner as illustrated in Fig. 6. In that case, the terminal members are positioned in correspondence to the individual terminals of the input terminal board 2A and 2B and the terminal pin block 16 which are to be formed by the terminal members. By way of example, the terminal members which are destined to constitute the individual terminals of the input terminal board 2A and the output terminal board 2B, respectively, are positioned at opposite ends of the metal substrate disposed horizontally so as to project laterally from the respective ends of the metal substrate.

Next, the metal substrate having the forward conversion circuit 47, the temperature detecting element 43 for the reverse conversion circuit and the main circuit direct current detecting resistor 42a and others mounted thereon is so positioned that the components mentioned just above are located within the power module 2 at a region indicated by a phantom line, whereupon the whole assembly is molded to an integral structure by using a preselected synthetic resin so that the terminal members mentioned above constitute the terminals of the input terminal board 2A, the output terminal board 2B and the terminal pin block 16, respectively. In this way, the power module 2 is manufactured.

Thus, in the inverter apparatus now under consideration, the main circuits of the inverter inclusive of the terminal boards are integrated to a resin molded structure of the power module 2 in the state where the wires have already been laid for interconnecting the individual components. Accordingly, works for mounting individually the forward conversion circuit 47, the reverse conversion circuit 48 and others as well as laying the wires among the main circuits of the power module 2 can be completely spared, which is very advantageous in that the manufacturing process is remarkably simplified.

Besides, because extraneous spaces otherwise required for the works for the mounting and the wiring can be spared, desired miniaturization of the inverter apparatus can be achieved.

In the inverter apparatus according to the instant embodiment of the invention, the electrolytic capacitors for the main circuit are mounted within the capacitor box, wherein the electrolytic capacitors are connected to the P- and N-terminals of the main circuit terminal board by way of wires laid internally of the inverter apparatus. However, the invention is never limited to such arrangement. The electrolytic capacitor may be disposed at a location independent of the power module 2 and connected to the P- and N-terminals by way of wires laid externally of the power module.

The inverter apparatus according to the instant embodiment of the invention provides numerous advantages and profits enumerated below:

(1) Considerable miniaturization of the inverter apparatus as a whole can be achieved.
(2) Because of remarkable reduction of the assembling steps as required, the manufacturing cost can considerably be reduced.
(3) Since the terminals for the power source and those for the load (induction motor) are disposed in opposition to each other, the wiring can be much facilitated.
(4) Because the inverter apparatus can be mounted on a switch board together with conventional electromagnetic switches, electrical connection of the inverter apparatus can be made through a conventional procedure with erroneous connection being essentially excluded.
(5) Since the mounting position for the smoothing capacitor can arbitrarily be selected, a significant freedom in design can be obtained when the inverter apparatus is to be installed within a user's electric instrument housing box.

In the case of the inverter apparatus described above, the electric connection for the electrolytic capacitor 6 placed within the capacitor box 5 is made by using the electric wires 15.

Consequently, when the electrolytic capacitor 6 is to be exchanged with a fresh one, it is required to remove the fastened terminals 15A fitted onto the associated electrode terminals of the capacitor.

Although the procedure involved in detaching the fastened terminal 15A is not troublesome, such procedure should preferably be spared, if it is possible.

Now, another embodiment of the invention directed to the capacitor box 5 will be described.

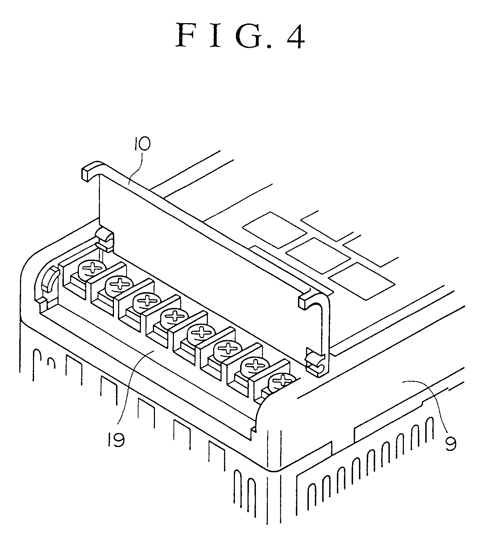

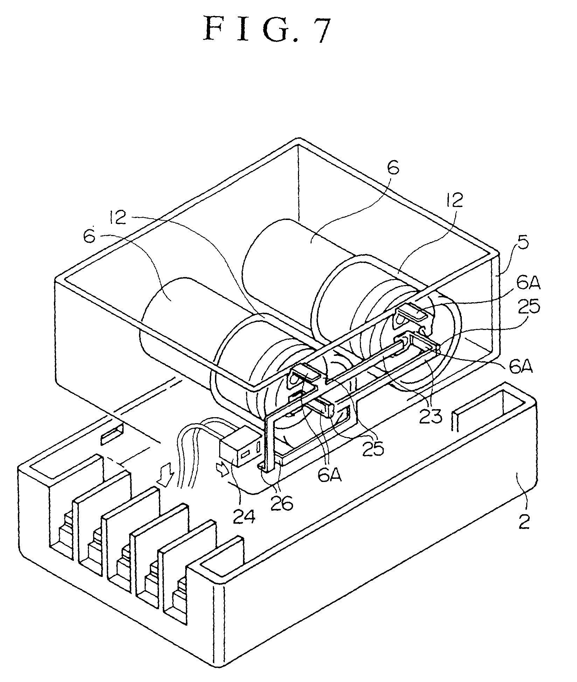

Figure 7 shows a structure of the capacitor box 5 according to another embodiment of the invention. In Fig. 7, a reference numeral 23 denotes a conductor bar formed of an electrically conductive material such as a copper strip and embedded on the frame (wall portion) of the capacitor box 5, a numeral 24 denotes a connector connected to the DC main circuit of the power module 2, a numeral 25 denotes a fastened terminal mounted on a tip end of the conductor bar 23, and a numeral 26 denotes a terminal pin portion formed in the conductor bar 23 at a tip end thereof. With regards to other structural respects, the capacitor box 5 now under consideration is substantially same as the embodiment described hereinbefore in conjunction with Figs. 2 to 6. Parenthetically, it should be mentioned that the capacitor box 5 is illustrated as a transparent box only for convenience of the description.

The fastened terminal 25 is mounted as projecting into the capacitor accommodating chamber 12 provided internally of the capacitor box 5 at such a position that upon insertion of the electrolytic capacitor 6 within the capacitor accommodating chamber 12, the electrode terminal 6A thereof can engage with the fastened terminal 25.

The terminal pin block 26 is also so formed as to extend into the capacitor box 5. By putting the connector 24 into engagement with the terminal pin block 26, the conductor bar 23 is electrically connected to the DC circuit of the power module 2.

Thus, by inserting the electrolytic capacitor 6 within the capacitor box 5 from the side of the electrode terminal 6A, placing the electrolytic capacitor 6 in the capacitor accommodating chamber 12 and then fitting the capacitor box cover 7 (not shown) from the rear side, the main circuit capacitor 6 is pushed into the capacitor accommodating chamber 12 with the electrode terminals 6A being inserted into the fastened terminals 25. Simply through this procedure, mounting of the electrolytic capacitor 6 onto the capacitor box 5 and electrical connection thereof to the DC main circuit can simultaneously be accomplished.

Thus, with the structure of the capacitor box 5 now under consideration, it is sufficient for mounting the capacitor box 5 on the main body to fit the projection 22 onto the terminal pin block 26 and then insert the electrolytic capacitor 6. Accordingly, upon exchange of the electrolytic capacitor 6, it is sufficient to pull out the electrolytic capacitor 6 without need for detaching the fastened terminal 15A of the electric wire 15. Of course, it is unnecessary to disassemble the main body for exchanging the electrolytic capacitor 6 with a new one.

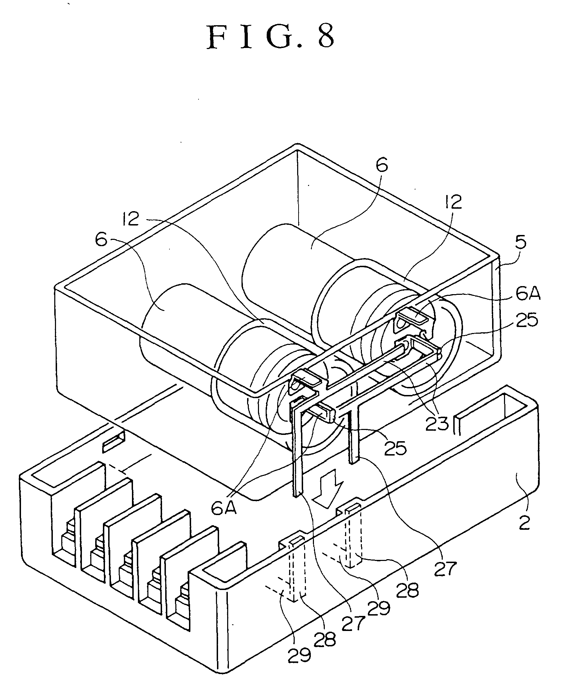

Figure 8 shows a modification of the capacitor box 5 shown in Fig. 7. In Fig. 8, reference numeral 27 denotes a terminal pin, numeral 28 denotes a pin receptacle formed in the case frame of the power module 2, and numeral 29 denotes an electrical conductor bar. Except for these components, others are essentially same as those described previously by reference to Fig. 7. Also in Fig. 8, the capacitor box 5 is illustrated as a transparent box only for convenience of the description.

The terminal pin portion 27 is formed at an end of the conductor bar 23 and projects in the direction toward the power module 2 from the wall of the capacitor box 5, as can be seen in the figure.

The pin receptacle 28 is implemented as a socket formed integrally with the wall of the power module 2 which opens at a position adjacent to the wall of the capacitor box 5 and is connected to the conductor bar 29.

The conductor bar 29 in turn has one end bonded to the conductor bar 29 and the other end connected to DC main circuit of the power module 2.

Thus, upon assembling of the main body of the inverter apparatus, it is only required to stack the capacitor box 5 on the power module 2 so that the terminal pin portions 27 are inserted in the openings of the pin receptacles 28, as indicated by an arrow in Fig. 8, whereby the conductor bar 23 connected to the electrode terminal 6A of the electrolytic capacitor 6 is contacted to the DC main circuit of the power module 2. By virtue of this structure, the connector 24 employed in the capacitor box shown in Fig. 7 can be spared, which means that the manufacturing steps can significantly be decreased with the cost being correspondingly reduced.

By the way, installation and connection of the electrolytic capacitor 6 are essentially same as those described hereinbefore in conjunction with the capacitor box shown in Fig. 7. Accordingly, repeated description will be unnecessary.

In the inverter apparatuses described in the foregoing, when the inverter apparatus is installed in such state that the input terminal board 2A and the output terminal board 2B are vertically oriented, mounting and removal of the electrolytic capacitor 6 are performed from a lateral side of the capacitor box 5, as can be seen from Figs. 2 and 3. However, the inverter apparatus may be configured such that the capacitor can be inserted or taken out from the top or bottom side in the state where the inverter apparatus is installed in the same orientation as mentioned above, an exemplary embodiment of which will be described below.

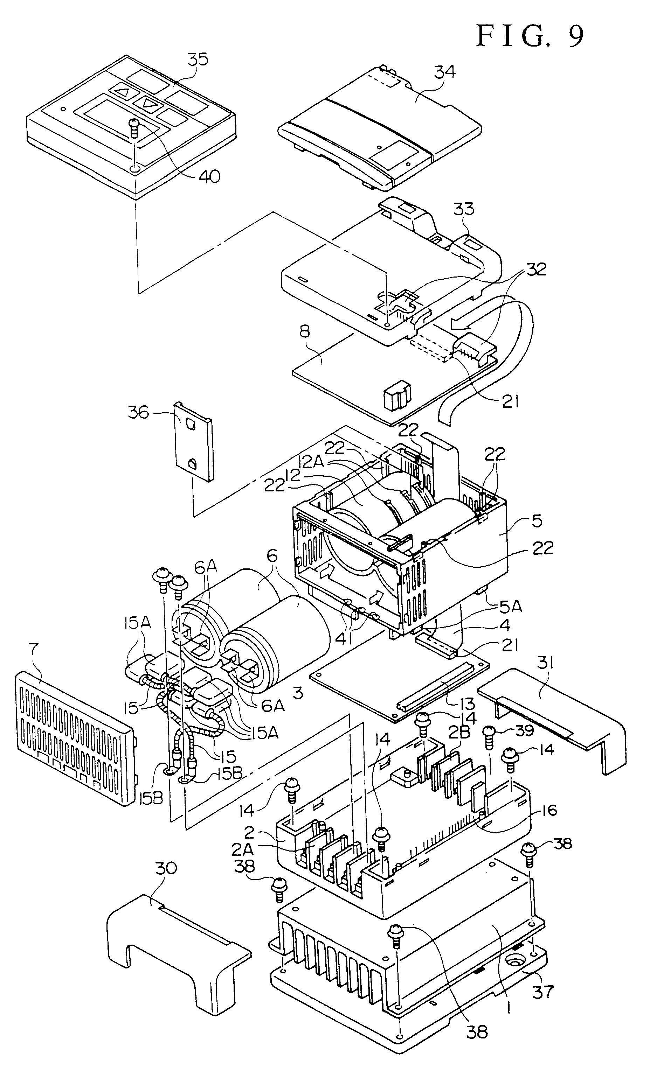

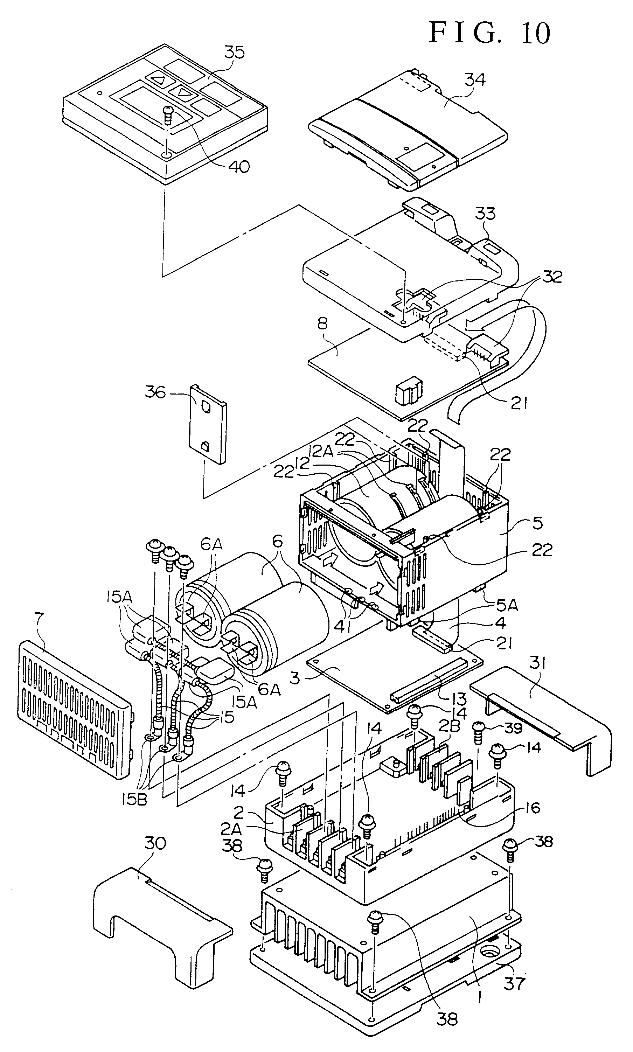

Figures 9 and 10 are exploded perspective views of an inverter apparatus according to another embodiment of the invention. In these figures, parts same as or equivalent to those described hereinbefore by reference to Fig. 2 are denoted by like reference characters.

In this conjunction, structural difference between the inverter apparatus shown in Fig. 9 and the one shown in Fig. 10 is seen only in the connection of the main circuit capacitor 6.

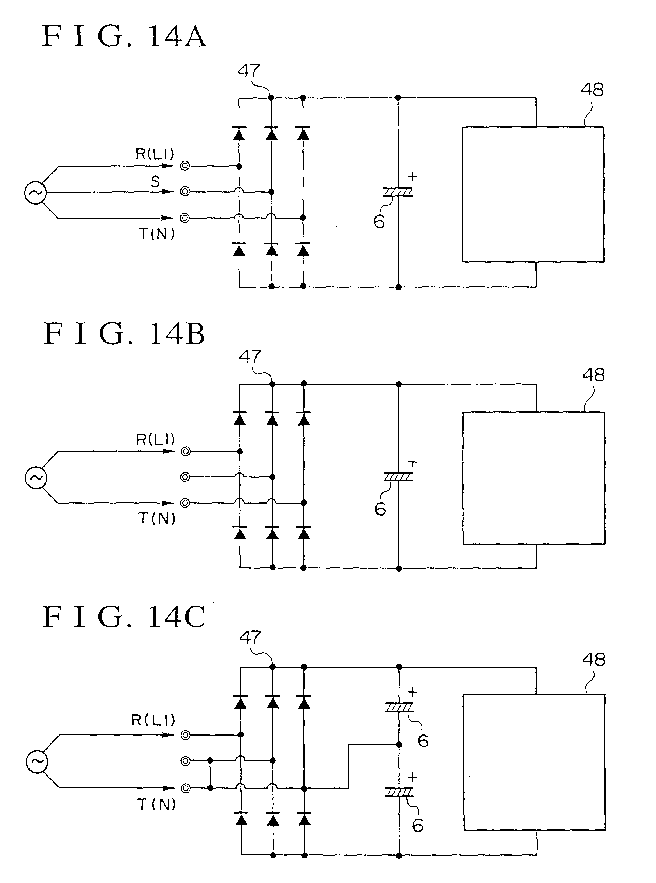

At first, it should be mentioned that in the case of the embodiment shown in Fig. 9, the inverter apparatus is intended for application to a three-phase power source of 200 V, as shown in Fig. 14A, and a single-phase power source of 200 V, as shown in Fig. 14B. Accordingly, a pair of main circuit capacitors 6 are connected in parallel with each other.

On the other hand, the inverter apparatus shown in Fig. 10 is designed for application to a single-phase power source of 100 V. For this reason, the forward conversion circuit 47 is implemented in the form of a voltage doubler full-wave rectifier circuit for deriving the output voltage of 200 V from the reverse conversion circuit 48 on the condition that the input voltage to the forward conversion circuit 47 of the inverter apparatus is 100 V. To this end, it is required to connect the two main circuit capacitors 6 in series to each other. Thus, the pair of capacitors 6 are connected in series, wherein the electric wire 15 is led out from the junction between the capacitors 6.

As mentioned previously, the inverter apparatuses shown in Figs. 9 and 10 are substantially same with regards to the parts denoted by same reference characters as those used in the description of the inverter apparatus shown in Fig. 2. Accordingly, the following description will be directed primarily to those portions which differ from the inverter apparatus shown in Fig. 2.

In Figs. 9 and 10, reference numerals 30 and 31 denote terminal board covers, respectively, numeral 32 denotes an interface connector, 33 denotes a control-circuit substrate cover, 34 denotes a surface cover, 35 denotes a digital manipulation panel, 36 denotes a capacitor stopper, 37 denotes DIN rail mounting fins, 38 denotes cooling fin fixing screws, 39 denotes a screw to be connected to the ground potential, 40 denotes digital manipulation panel fixing screws, 41 denotes wire through-holes, and reference character 12A denotes grooves formed in the capacitor accommodating chamber 12.

In the first place, it should be mentioned that in the case of the inverter apparatuses shown in Figs. 9 and 10, the main circuit terminal boards 2A and 2B are provided with the terminal board covers 30 and 31, respectively.

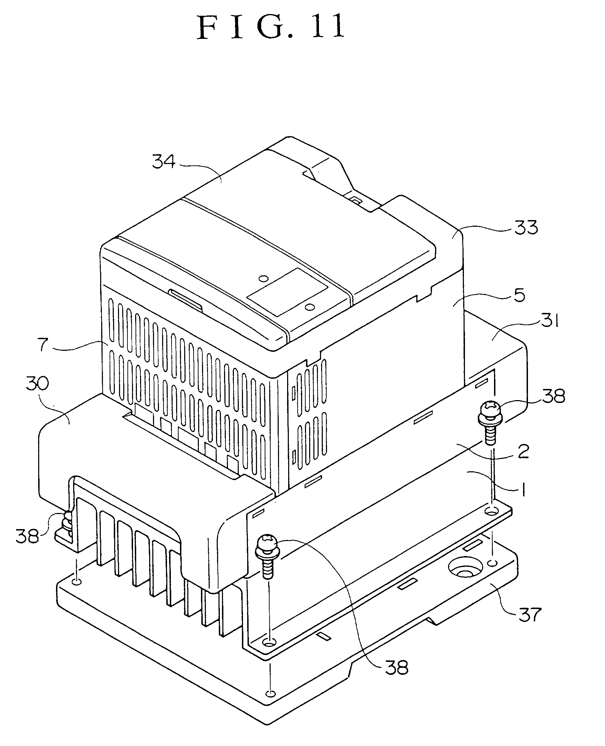

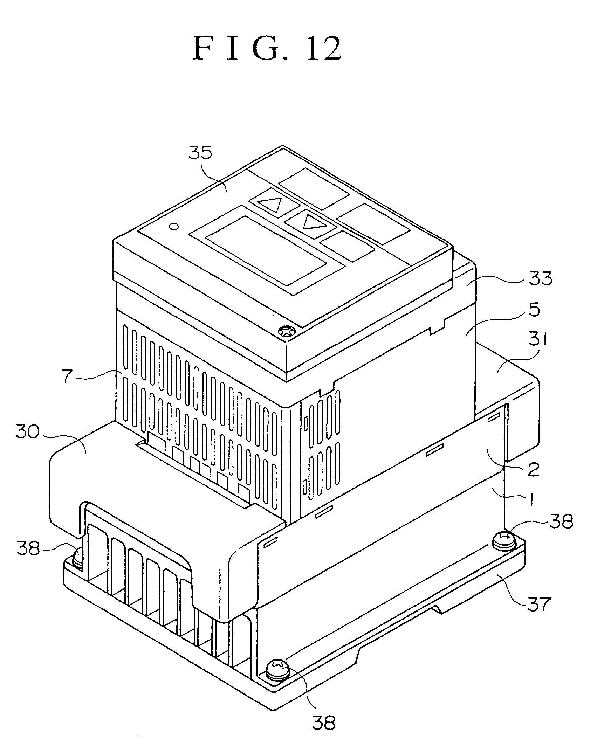

More specifically, the terminal board covers 30 and 31 are removably mounted on the main circuit terminal boards 2A and 2B, respectively, so that upon connection of the electric wires to the terminal board, the terminal board cover 30 or 31 is removed and otherwise held in the state mounted on the terminal board, as shown in Figs. 11 and 12.

Since the main circuit of the inverter handles a high voltage, contact with the fittings of the input terminal board 2A or 2B is dangerous for the operator. Besides, intrusion of metallic pieces may give rise to occurrence of short-circuit fault.

However, in the case of the inverter apparatus now under consideration, the main circuit terminal board is covered with the terminal board covers 30 and 31 when the inverter apparatus is in service, as can be seen from Figs. 11 and 12. Thus, the inverter apparatus can be protected against unforeseen accidents.

In the inverter apparatus shown in Figs. 9 and 10, the interfacing connector 32 is mounted on the control substrate 8.

Thus, the user can easily make connection upon interfacing with external equipment.

Further, in the inverter apparatus under discussion, the interfacing connection module is divided into two interfacing connectors 32. Thus, a control signal line which is to be used frequently may be connected to one of the interfacing connectors 32 while other signal line may be connected through the other interfacing connector 32.

In the inverter apparatus shown in Figs. 9 and 10, the control-circuit substrate cover 33 is mounted on the control substrate 8, wherein the surface cover 34 may be mounted on or over the control-circuit substrate cover 33, as shown in Fig. 11, or alternatively the digital manipulation panel 35 may be disposed on the control-circuit substrate cover 33, as the case may be.

In other words, the number of the functions which can be selected by the user is increased in the case of the inverter apparatus according to the instant embodiment of the invention.

Parenthetically, the surface cover 34 is removably mounted on the control-circuit substrate cover 33 by fitting the claws into the recesses, while the digital manipulation panel 35 is removably secured by using screws 40.

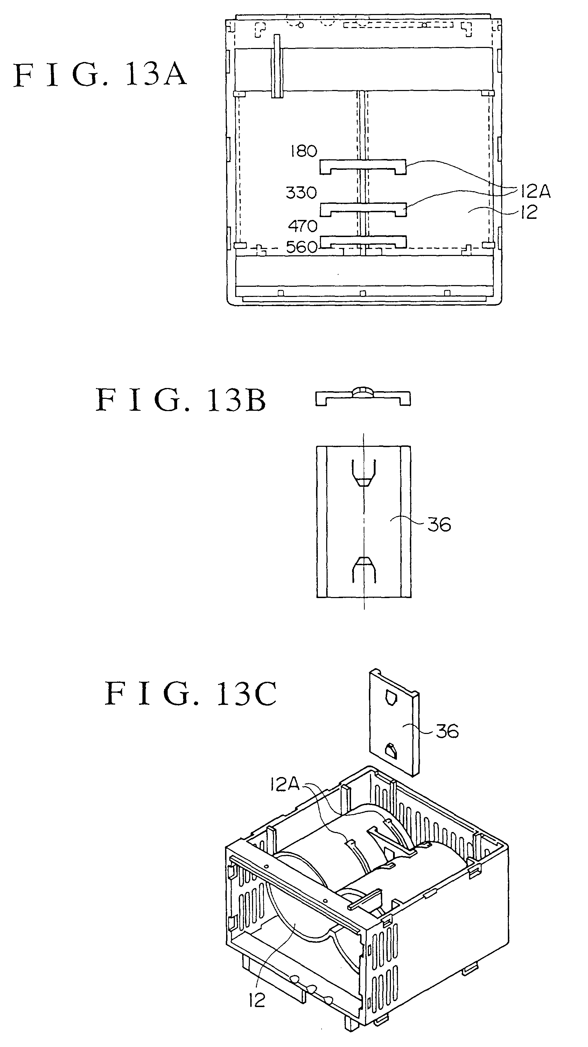

Furthermore, in the inverter apparatuses shown in Figs. 9 and 10, the capacitor accommodating chamber 12 is formed with a plurality of grooves 12A (e. g. three grooves), as is shown in Fig. 13A. In one of these groves, a capacitor stopper 36 shown exaggeratedly in Fig. 13B is fixedly fitted in such a manner as shown in Fig. 13C.

In general, in the inverter apparatuses, it is required to use the capacitor having the electrostatic capacity which differs in dependence on the rated output power. By way of example, one of the capacitors 6 having electrostatic capacities of 180 μF, 330 μF and 470 μF will have to be selectively used.

As the capacitor, a cylindrical one is conventionally used. In that case, the electrostatic capacity of the capacitor is changed usually by changing the length thereof with the diameter being left intact. Thus, the capacitor of greater electrostatic capacity has a correspondingly increased length.

Accordingly, in the inverter apparatus now under consideration, the position of the groove 12A is adapted to be changed in correspondence to the lengths of the capacitors having different electrostatic capacities. By way of example, when the electrolytic capacitor having the electrostatic capacity of 180 μF is to be used, the capacitor stopper 36 is disposed in the groove 12A as indicated at 180 in Fig. 13A. Similarly, in dependence on the electrostatic capacities of the electrolytic capacitors, the capacitor stopper 36 is fixedly fitted in the groove 12A indicated at 330 or 470.

In this manner, in the inverter apparatus according to the instant embodiment of the invention, a given one of the electrolytic capacitors having different electrostatic capacities can selectively be used. In other words, when electrolytic capacitors having different lengths are to be used for the inverter apparatuses of different rated capacities, the capacitor stopper 36 can be used for determining the position at which the electrolytic capacitor 6 of a given length is to be fixedly and stably disposed.

Although three grooves 12A are provided in the case of the inverter apparatus according to the instant embodiment of the invention, it goes without saying that two or more grooves may be provided.

Again referring to Figs. 9 and 10, the DIN rail mounting fins 37 is secured onto the cooling fin unit 1 by means of screws 38 for allowing the inverter apparatus to be used even in the system where a DIN rail is employed.

The phrase "DIN rail" means a member for mounting a switch board as stipulated in the German Industrial Standards, which is widely used in European countries. Thus, the inverter apparatus according to the instant embodiment of the invention can find applications over a wide range.

In conjunction with the inverter apparatuses shown in Figs. 9 and 10, it should further be noted that the capacitor box 5 is formed with wire through-holes 41 through which the electric wires 15 of the electrolytic capacitor 6 are led out to be directly connected to the terminals of the input terminal board 2A for the power source.

The input terminal board 2A is provided with the terminals for R-, S- and T-phases of the commercial power source together with P- and N-terminals for the DC power. Thus, by connecting two electric wires 15 extending from the electrolytic capacitors 6 to the P-and N-terminals, respectively, of the input terminal board 2A, the inverter apparatus can serve as a three-phase power source of 200 V, as shown in Fig. 14A or alternatively as a single-phase power source of 200 V, as shown in Fig. 14B. On the other hand, by connecting three electric wires 15 extending from the main circuit electrolytic capacitors 6 to the P- and N-terminals and those for S- and N-phases of the input terminal board 2A, as shown in Fig. 10, the inverter apparatus can serve as a single-phase power source of 100 V. In other words, the inverter apparatus according to the instant embodiment of the invention can operate as the single-phase inverter of 200 V or as the single-phase inverter of 100 V simply by changing the electric connections for the electrolytic capacitors without any material modification of the inverter apparatus which is originally implemented as a three-phase inverter of 200 V.

By the way, the inverter apparatus shown in Figs. 9 and 10 is implemented such that the main circuit capacitor 6 is mounted or removed from the top of the capacitor box 5. It should however be mentioned that the inverter apparatus may equally be so structured that the electrolytic capacitor 6 can be mounted or removed from a bottom side.

Of course, the inverter apparatus shown in Figs. 9 and 10 may have such a structure that the electrolytic capacitor 6 can be mounted and/or removed from a lateral side of the capacitor box 5 and hence from a lateral side of the inverter apparatus.

It will now be appreciated that with the structures of the capacitor box described above, the number of assembling steps can be decreased, whereby the manufacturing cost of the inverter apparatus can significantly be reduced. Besides, because the direction along which the smoothing capacitor is inserted and/or removed can be selected rather arbitrarily, there can be obtained a great freedom in design in installing the inverter apparatus within an electric device housing box.

Next, description will turn to an inverter apparatus 42 according to another embodiment of the invention in which an inverter implemented by using the power module 2 described above and a noise elimination filter are disposed on the cooling fin unit.

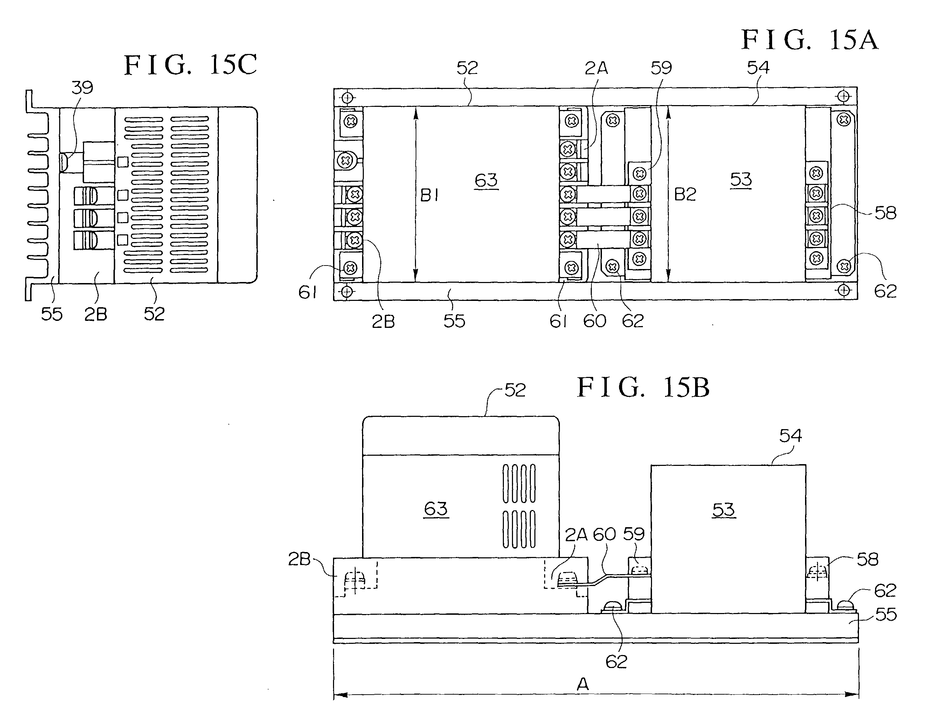

Figures 15A, 15B and 15C show in a top plan view, a side elevational view and an end view, respectively, an inverter apparatus including an inverter mounted on a cooling fin unit with a noise elimination filter being inserted at the power source side of the inverter according to a further embodiment of the invention. In these figures, reference numeral 63 denotes an inverter unit, numeral 52 denotes a metal case of the inverter unit 63, numeral 53 denotes a noise elimination filter module, numeral 54 denotes a metal case of the noise elimination filter module 53, numeral 55 denotes a cooling fin unit, characters 2A and 2B denote terminal boards for the inverter unit 63, numerals 58 and 59 denote terminal boards for a noise elimination filter module 53, numeral 60 denotes a conductor bar, numeral 61 denotes screws for securing the inverter unit 63, numeral 62 denotes screws for securing the noise elimination filter module 53, and a numeral 39 denotes a screw serving as an earth terminal.

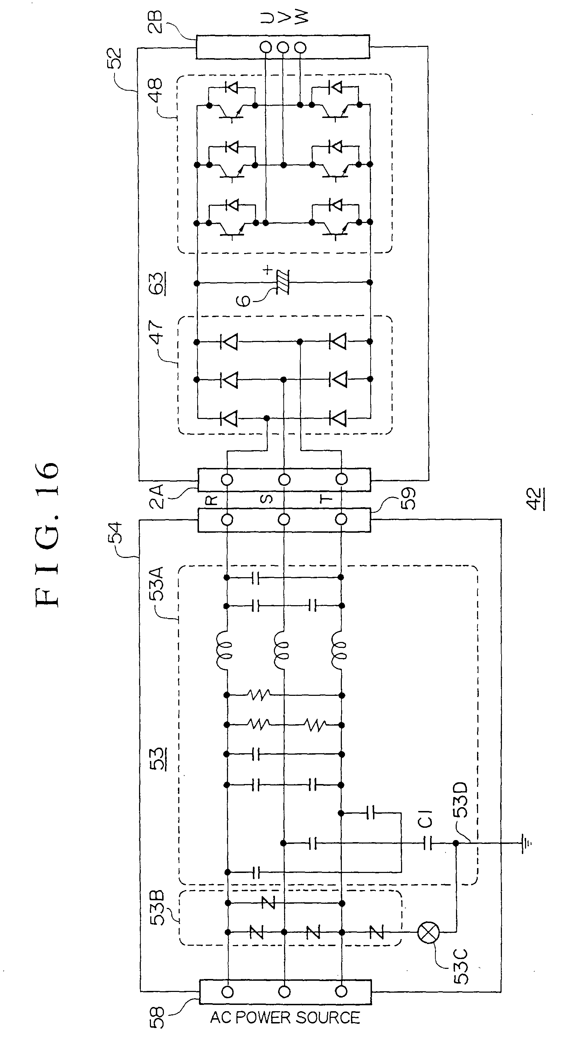

A major part of the inverter unit 63 is constituted by the forward conversion circuit 47, the smoothing capacitor 6 and the reverse conversion circuit 48, as shown in Fig. 16. The AC input of the forward conversion circuit 47 is connected to the input terminal board 2A for the power supply, while the AC output of the reverse conversion circuit 48 is connected to the output terminal board 2B for a load.

The components mentioned above are assembled in a unit and housed within the metal case 52, which is then fixedly mounted on a surface of the cooling fin unit 55 by means of four screws 61.

On the other hand, the noise elimination filter module 53 is comprised of a filter circuit 53A, a surge absorber circuit 53B, an arrester element 53C and an internal earth line 53D, wherein the terminal board 58 for the power source is connected to the noise elimination filter module 53B, the terminal board 59 on the side of the inverter is connected to the filter circuit 53A, and wherein the internal earth line 53D serves for connecting a capacitor C1 constituting a part of the filter circuit 53A and the arrester element 53C to the metal case 54, as can be seen from Fig. 16.

The components mentioned above are assembled to a single unit and housed within a metal case 54 to be mounted on a flat surface of the cooling fin unit 55 by means of four screws 62.

The conductor bar 60 is employed for interconnecting the inverter unit 63 and the noise elimination filter module 53. More specifically, the conductor bar 60 is interposed between the terminal board 59 of the noise elimination filter module 53 and the input terminal board 2A of the inverter unit 63 for electrical interconnection thereof.

Thus, by connecting the terminal board 58 of the noise elimination filter module 53 to the AC power source, an AC voltage is supplied to the inverter unit 63 to be converted to a DC voltage by the forward conversion circuit 47, wherein ripple components of the DC voltage are suppressed by the smoothing capacitor 6. The smoothed DC voltage is then supplied to the reverse conversion circuit 48 to be converted to an AC voltage of a variable frequency, which is then outputted from the output terminal board 2B to be supplied to a load such as an induction motor.

Since the AC-to-DC conversion is realized by switching operation of the reverse conversion circuit 48 of the inverter unit 63, as mentioned hereinbefore, high-frequency noise voltage is likely to make appearance in the output of the inverter unit 63, as a result of which a noise current tends to flow toward the power source. However, because of filtering operation of the filter circuit 53A, influence of the noise current to other machines and/or apparatuses connected to a same power source system can substantially be suppressed.

Now, turning back to Fig. 15, the inverter apparatus under discussion is intended to be installed on a wall of a building. Thus, when the inverter apparatus is mounted in a vertical orientation, the inverter unit 63 is mounted on the cooling fin unit 55 serving as the base such that the left-hand side of the inverter unit 63 as viewed in Fig. 15 is positioned at bottom with the right-hand side positioned atop. Consequently, the electric wires extending from the power source are connected to the terminal board 58 from the top side, while the electric wires for the load are led out from the bottom side of the output terminal board 2B.

In the inverter apparatus according to the instant embodiment of the invention, the inverter unit 63 assembled as a unit and housed within the metal case 52 and the noise elimination filter module 53 similarly implemented as a unit and accommodated within the metal case 54 are mounted vertically in juxtaposition on one and the same surface of the cooling fin unit 55 by means of the screws 61 and 62, respectively.

As a result of this, the input terminal board 2A for the power source located above the inverter unit 63 and the terminal board 59 below the noise elimination filter module 53 are disposed in opposition to each other with a possible shortest distance therebetween.

Thus, by virtue of the arrangement mentioned above, the length of the conductor bar 60 connecting the inverter unit 63 and the noise elimination filter module 53 to each other can be made shortest without need for any roundabout wiring, whereby noise suppression can be realized with very high efficiency.

Since the inverter unit 63 and the noise elimination filter module 53 are fixedly secured onto the cooling fin unit 55 in common, the positional relation between them is positively prevented from changing even upon installation of the inverter apparatus, whereby characteristics of the latter can be protected against change or degradation while ensuring a high noise suppression function for the inverter apparatus 42.

In the inverter apparatus now under consideration, the screw 39 is threaded screwwise into the cooling fin unit 55 to serve as a terminal for allowing connection of a ground or earth line.

Namely, by connecting the screw 39 to the earth, the cooling fin unit 55 can easily be connected to the ground potential thereto.

On the other hand, the noise elimination filter module 53 is fixedly mounted on the cooling fin unit 55 by the screws 62. Thus, the metal case 54 is grounded via the screws 62 and hence the capacitor C1 constituting a part of the filter circuit is positively grounded via the internal earth line 53D, as shown in Fig. 16. Owing to this arrangement, the noise suppressing function of the noise elimination filter module 53 can positively be ensured.

As can be seen from Fig. 15, the cooling fin unit 55 is manufactured through an extrusion molding.

Accordingly, the length A in the extruding direction shown in the figure can be selected rather arbitrarily without changing the extrusion die.

Thus, by selecting the width B1 of the inverter unit 63 and the width B2 of the noise elimination filter module 53 such that the condition:

$$B1 \geq B2$$

is satisfied, the cooling fin unit 55 can be manufactured with optimal lengths simply by changing the dimension A for both the case where the inverter unit 63 is solely used without combination with the noise elimination filter and the case where the inverter unit 63 and the noise elimination filter module 53 are implemented in an integral structure.

Thus, the inverter apparatus according to this embodiment can easily and inexpensively manufactured for the application where no noise elimination filter is required.

It is further noted that since the cooling fin unit 55 is enlarged by an amount corresponding to the size of the noise elimination filter module 53, the heat dissipation effect can correspondingly be enhanced. Thus, by using a fin structure designed for a low rated inverter, the inverter apparatus 42 of a greater capacity can be realized.

For interconnection of the inverter unit 63 and the noise elimination filter module 53, there is used the conductor bar 60 which can previously be manufactured by stamping a copper sheet or the like with high dimensional precision. Thus, the assembling procedure can be much simplified when compared with the case where the inverter unit 63 and the noise elimination filter module 53 are connected by using the electric wires and terminal members.

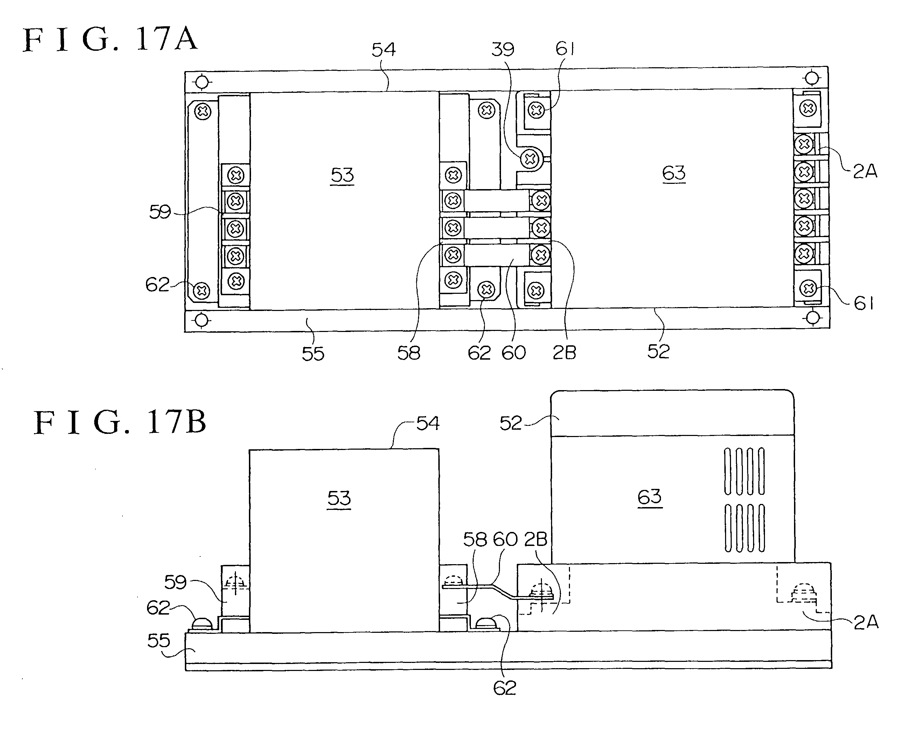

Figures 17A and 17B show in a top plan view and a side view, respectively, another embodiment of the invention which is also directed to a combination of the inverter unit 63 and the noise elimination filter module 53. In the case of the inverter apparatus described above by reference to Fig. 15, the noise elimination filter module 53 is disposed at the power source side of the inverter unit 63. By contrast, in the inverter apparatus shown in Fig. 17, the noise elimination filter module 53 is disposed at the output side (load side) of the inverter. Accordingly, when the inverter apparatus according to the instant embodiment is installed vertically with the left-hand side as viewed in Fig. 17 being positioned at bottom with the right-hand side atop, the inverter unit 63 is mounted on the cooling fin unit 55 serving as the base at the right-hand side while the noise elimination filter module 53 is positioned at the left-hand side. Except for this positional difference, the inverter apparatus shown in Fig. 17 is substantially same as that shown in Fig. 15.

Accordingly, in the inverter apparatus shown in Fig. 17, the output terminal board 2B of the inverter unit 63 for load is connected to the terminal board 58 of the noise elimination filter module 53 by the conductor bar 60.

The electric wires extending from the AC power source are connected to the input terminal board 2A of the inverter unit 63 disposed atop, while the electric wires leading to the load are connected to the terminal board 59 of the noise elimination filter module 53. The inverter apparatus shown in Fig. 17 can advantageously be employed for the application where the load is to be protected against influence of noise.

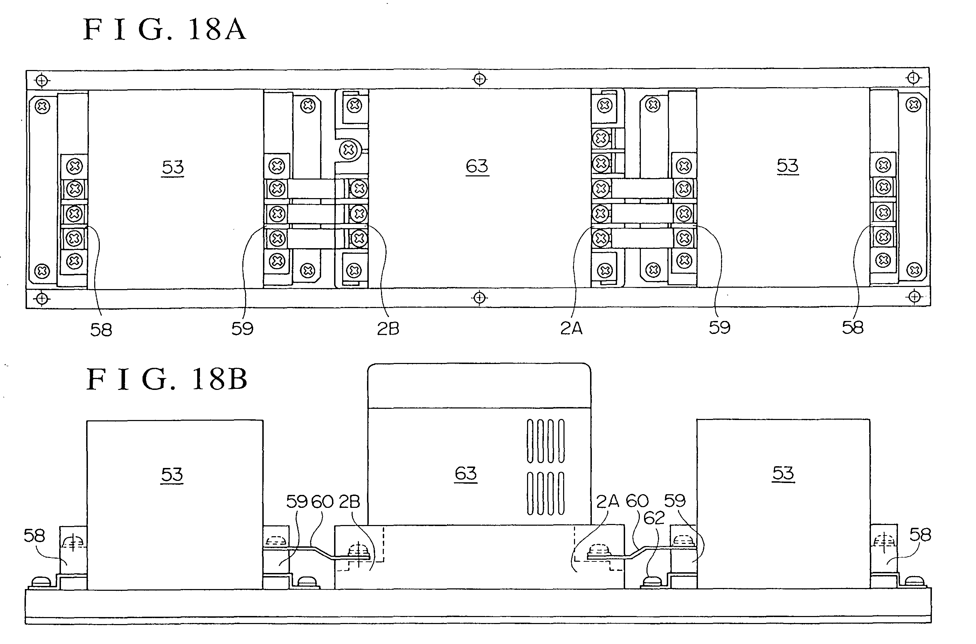

Figures 18A and 18B show, respectively, in a top plan view and a side elevational view an inverter apparatus including a combination of the inverter unit 63 and the noise elimination filter module 53 according to yet another embodiment of the invention.

In the inverter apparatus according to this embodiment, noise elimination filters are provided at the AC power source side of the inverter unit 63 and at the load side, respectively. More specifically, an input-side noise elimination filter module 53 and a load-side noise elimination filter module 53 are mounted on the cooling fin unit 55 above (at the right-hand side of) and beneath (at the left-hand side of) the inverter unit 63, respectively.

The inverter apparatus according to the instant embodiment of the invention is advantageous in that the inverter unit can be mounted with a small number of securing screws and that any especial consideration need not be paid to the wiring for grounding, notwithstanding of the fact that two noise elimination filters are used, wherein influence of harmonic noise and radiation noise of the inverter apparatus 42 can sufficiently be suppressed.

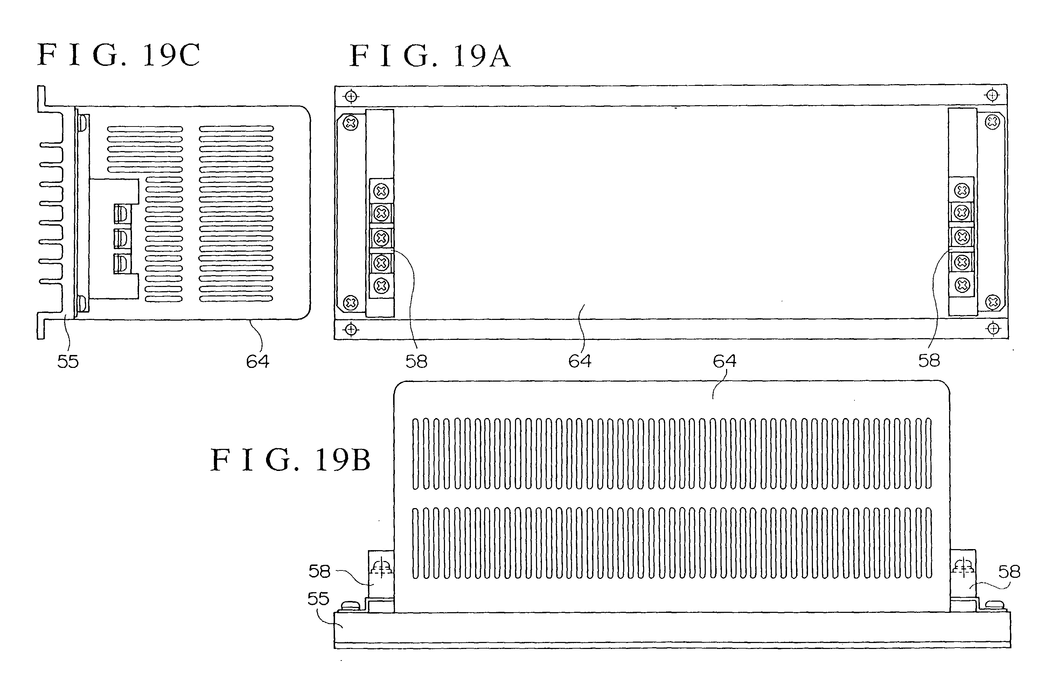

Figures 19A, 19B and 19C show in a top plan view, a side elevational view and a bottom plan view an inverter apparatus including a combination of the inverter unit 63 and a noise elimination filter 53.

The inverter apparatus according to this embodiment of the invention differs from the apparatus shown in Fig. 18 in that in place of the metal cases 52 and 54 provided for the inverter unit 63 and the two noise elimination filter modules 53, a metal cover 64 for housing in common both the inverter unit 63 and the noise elimination filter module 53 is employed.

Since the inverter unit 63 as well as the noise elimination filter modules 53 disposed at both sides thereof, inclusive of the conductor bar 60, are wholly covered by the metal cover 64, not only noise emitted from the inverter unit 63 can positively be shielded but also the inverter unit 63 can be protected against influence of external electric field and magnetic fields. Thus, the inverter apparatus can enjoy a high insusceptibility to noise.

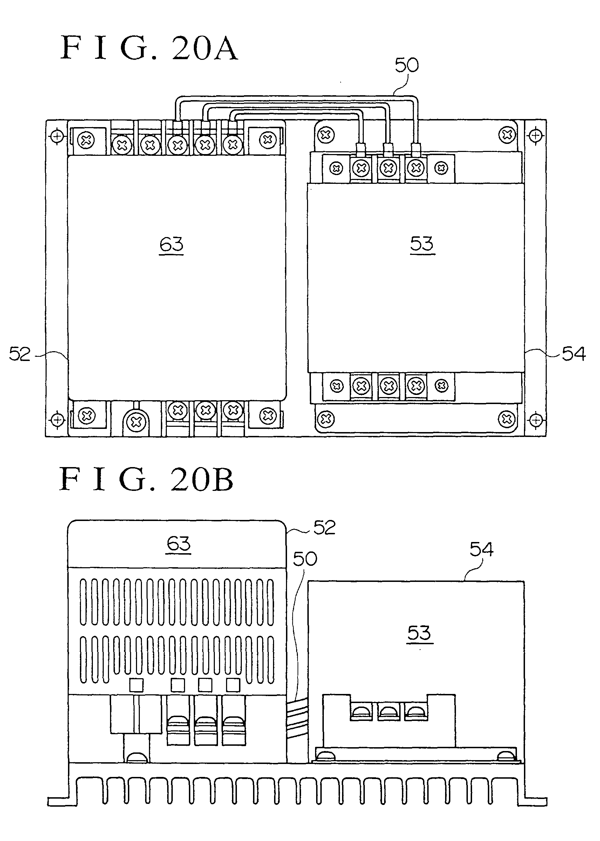

The metal cover 64 can be employed in the inverter apparatuses shown in Figs. 15 and 17 as well. Besides, it can be used in the inverter apparatus shown in Fig. 20, which will be described below.

Figures 20A and 20B show, respectively, in a top plan view and a side elevational view an inverter apparatus including a combination of the inverter unit 63 and the noise elimination filter module.

In the case of the inverter apparatus according to the instant embodiment of the invention, the inverter unit 63 and the noise elimination filter module 53 are disposed on the cooling fin unit 55 in juxtaposition in the horizontal direction.

In this inverter apparatus, the inverter unit 63 and the noise elimination filter module 53 are electrically interconnected by using the electric wires 50 disposed atop of the inverter apparatus. Accordingly, the input connection to the AC power source and the output connection to the load are both made at the bottom side of the inverter apparatus.

In the case of the inverter apparatuses shown in Figs. 15 to 19, the inverter unit 63 and the noise elimination filter module 53 are juxtaposed in the vertical direction. Accordingly, these inverter apparatuses are advantageous when space is unavailable in the horizontal or lateral direction upon mounting the inverter apparatus on a wall of a building. By contrast, the inverter apparatus shown in Fig. 20 can profitably be mounted in a place where available space is limited in the vertical direction.

With the structures of the inverter apparatuses each including combination of the inverter unit 63 and the noise elimination filter module 53, as described above by reference to Figs. 15 to 20, the terminal board of the inverter unit 63 and that for the load can be disposed separately in opposition to each other with the inverter unit being interposed therebetween. By virtue of this arrangement, the interconnecting wires for the inverter unit 63 and the noise elimination filter module 53 can be shortened to a possible minimum. Additionally, the wirings at the input and output sides of the noise elimination filter module 53 can be separated without difficulty. Furthermore, since the inverter unit 63 and the noise elimination filter module 53 are mounted on the same surface of the cooling fin unit 55, connection to the ground potential can be realized by using a single common terminal, whereby the noise suppression function of the noise elimination filter can be exhibited adequately. Thus, there is realized the inverter apparatus 42 which can enjoy an extremely low conduction noise level (terminal noise voltage level).

Further, owing to the structure in which both the inverter unit 63 and the noise elimination filter module 53 are wholly housed within the metal case, the filter function can further be enhanced, whereby radiation noise intensity level (electric field noise level) of the inverter apparatus 42 can be suppressed remarkably.

Furthermore, because the inverter unit 63 and the noise elimination filter module 53 can simultaneously be grounded by a single wire via the earth terminal, the noise elimination function is not affected by the grounding condition, whereby reliable noise suppression can constantly be ensured for the inverter apparatus 42.

Consequently, the inverter unit 63 and the noise elimination filter module 53 can be disposed sufficiently closely to each other irrespective of the states in which the inverter apparatus is installed, which in turn means that the length of the interconnecting wires can be shortened. Besides, owing to the shield effect provided by the cooling fin unit 55, filter function can be exhibited adequately. For these reasons, the inverter apparatus 42 inclusive of the noise elimination filter module can be implemented in a much miniaturized structure.

Besides, in the applications where the noise elimination filter is not required, the cooling fin unit may have only the inverter unit 63 mounted thereon. In that case, the manufacturing cost of the inverter apparatus can significantly be reduced, to a further advantage.

**Claims**

1. An inverter apparatus (42) comprising at least a forward conversion circuit (47) for deriving a DC power from an AC power, a reverse conversion circuit (48) for converting a DC power to an AC power, a smoothing capacitor (6), an input terminal board (2A) and an output terminal board (2B), wherein

   at least said forward conversion circuit (47) and said reverse conversion circuit (48) are disposed on one surface of a substrate of a substantially rectangular shape, and
   pluralities of terminal members are disposed at said substrate, **characterised in that**
   said substrate is a metal substrate,
   said pluralities of terminal members are disposed at opposite ends of said metal substrate such that said input terminal board (2A) is formed at the one end of said metal substrate and said output terminal board (2B) is formed at the other end of said metal substrate to thereby constitute a main-circuit terminal board integrated unit (2), and
   said forward conversion circuit (47) and said reverse conversion circuit (48) as well as said terminal members are moulded in an integral structure.

2. An inverter apparatus (42) according to claim 1, wherein said metal substrate of said main circuit terminal board integrated module (2) is mounted on a cooling fin unit (1), and a circuit substrate (3) packaged with a drive circuit for driving said reverse conversion circuit (48) and a circuit substrate (8) packaged with a capacitor (6) for smoothing a DC output voltage of said forward conversion circuit (47) and a logic module for generating drive signals for said drive circuit are sequentially stacked on the surface of said metal substrate in opposition to said cooling fin unit (1).

3. An inverter apparatus (42) according to claim 2, wherein said input terminal board is equipped with terminals (P, N) connected to a main circuit DC bus, and wherein connecting wires (15) extend from said terminals to said capacitor (6).

4. An inverter apparatus (42) according to claim 1, **characterized in that** said inverter apparatus further comprises a frame structure (5) of a shallow box-like shape formed in a portion of a case of said inverter apparatus, a capacitor accommodating chamber (12) formed internally of said frame structure, and connecting terminals capable of being resiliently mounted and removed, and that mechanical mounting of said capacitor (6) to said inverter apparatus (42) is realized by inserting said capacitor (6) into said capacitor accommodating chamber (12), while electrical connection to said capacitor (6) is realized by inserting said connecting terminals (15A or 25) to electrode terminals (6A) of said capacitor (6).

5. An inverter apparatus (42) according to claim 4, **characterized in that** said capacitor accommodating chamber (12) is formed in one wall internally of said frame structure (5), that an aperture is formed in a wall disposed in opposition to said one wall, and that a member (7) covering said aperture is mounted removably from the outside of said frame structure (5).

6. An inverter apparatus (42) according to claim 4, **characterized in that** said connecting terminals (15A or 25) are connected to a main circuit of the inverter by way of insulated wires (15) or conductor bars (23).

7. An inverter apparatus (42) according to claim 4, **characterized in that** said connecting terminals (25) are provided internally of said capacitor accommodating chamber (12), and that when said capacitor (6) is inserted into said capacitor accommodating chamber (12), said electrode terminals of said capacitor (6) are brought into engagement with said connecting terminals (25) to thereby make said electrical connection.

8. An inverter apparatus (42) according to claim 4, **characterized in that** said capacitor accommodating chamber (12) has at least two grooves (12A,12B) formed therein sequentially at different positions as viewed in the direction in which said capacitor is inserted, and that a capacitor positioning member (36) is selectively fitted in one of said grooves.

**Patentansprüche**

1.  Umrichter (42) mit wenigstens einer Gleichrichterschaltung (47) zum Erzeugen einer Gleichspannung aus einer Wechselspannung, einer Wechselrichterschaltung (48) zum Umsetzen einer Gleichspannung in eine Wechselspannung, einem Glättungskondensator (6), einer Eingangsklemmenplatte (2A) und einer Ausgangsklemmenplatte (2B), wobei

    wenigstens die Gleichrichterschaltung (47) und die Wechselrichterschaltung (48) auf einer Fläche eines Substrats von im wesentlichen rechteckiger Form angeordnet sind, und mehrere Anschlußklemmen auf dem Substrat angeordnet sind,

    **dadurch gekennzeichnet, daß**

    das Substrat aus Metall besteht, die mehreren Anschlußklemmen an entgegengesetzten Seiten des Metallsubstrats angeordnet sind, so daß die Eingangsklemmenplatte (2A) auf der einen Seite des Metallsubstrats und die Ausgangsklemmenplatte (2B) auf der anderen Seite des Metallsubstrats gebildet ist, um so eine integrierte Hauptkreis-Klemmenplatteneinheit (2) zu schaffen, und die Gleichrichterschaltung (47) und die Wechselrichterschaltung (48) ebenso wie die Anschlußklemmen in eine einstückige Struktur geformt sind.

2.  Umrichter (42) nach Anspruch 1, wobei

    das Metallsubstrat des integrierten Hauptkreis-Klemmenplattenmoduls (2) auf einer Kühlrippeneinheit (1) angebracht ist, ein mit einer Betriebsschaltung zum Betreiben der Wechseirichterschaltung (48) zusammengepacktes Schaltungssubstrat (3), ein mit einem Kondensator (6) zum Glätten einer Ausgabe-Gleichspannung der Gleichrichterschaltung (47) zusammengepacktes Schaltungssubstrat (8) und ein Logikmodul zum Erzeugen von Betriebssignalen für die Betriebsschaltung sequentiell auf der zum Metallsubstrat entgegengesetzten Fläche der Kühlrippeneinheit (1) gestapelt sind.

3.  Umrichter (42) nach Anspruch 2, wobei

    die Eingangsklemmenplatte mit an einen Hauptkreis-Gleichstrom-Bus angeschlossenen Klemmen (P, N) ausgestattet ist, und Verbindungsdrähte (15) von den Klemmen zu dem Kondensator (6) laufen.

4.  Umrichter (42) nach Anspruch 1, **dadurch gekennzeichnet, daß**

    er weiterhin eine Rahmenstruktur (5) von flacher, schachtelartiger Form, die in einem Gehäuseteil des Umrichters gebildet ist, eine den Kondensator aufnehmende Kammer (12), die innerhalb der Rahmenstruktur gebildet ist, und federnd montier- und demontierbare Verbindungsklemmen aufweist, und die mechanische Anbringung des Kondensators (6) an den Umrichter (42) durch Einsetzen des Kondensators in die den Kondensator aufnehmende Kammer (12) realisiert wird, während der elektrische Anschluß an den Kondensator (6) durch Einsetzen der Verbindungsklemmen (15A oder 25) an Elektrodenanschlüsse (6A) des Kondensators (6) realisiert wird.

5.  Umrichter (42) nach Anspruch 4, **dadurch gekennzeichnet, daß**

    die den Kondensator aufnehmende Kammer (12) in einer Wand innerhalb der Rahmenstruktur (5) gebildet ist, eine Öffnung in einer dieser Wand gegenüberliegenden Wand gebildet ist, und ein diese Öffnung überdeckendes Bauteil (7) von außerhalb der Rahmenstruktur (5) abnehmbar angebracht ist.

6.  Umrichter (42) nach Anspruch 4, **dadurch gekennzeichnet, daß** die Verbindungsklemmen (15A oder 25) über isolierte Drähte (15) oder Leiterschienen (23) an einen Hauptkreis des Umrichters angeschlossen sind.

7.  Umrichter (42) nach Anspruch 4, **dadurch gekennzeichnet, daß**

    die Verbindungsklemmen (25) innerhalb der den Kondensator aufnehmenden Kammer (12) vorgesehen sind, und die Elektrodenanschlüsse des Kondensators (6) zur Herstellung eines elektrischen Kontakts in Eingriff mit den Verbindungsklemmen (25) gebracht werden, wenn der Kondensator (6) in die den Kondensator aufnehmende Kammer (12) eingesetzt wird.

8.  Umrichter (42) nach Anspruch 4, **dadurch gekennzeichnet, daß**

    die den Kondensator aufnehmende Kammer (12) wenigstens zwei Nuten (12A, 12B) aufweist, die darin der Reihe nach an bezüglich der Richtung, in der der Kondensator eingesetzt wird, verschiedenen Positionen gebildet sind, und

ein Kondensator-Positionierglied (36) selektiv in eine der Nuten eingesetzt wird.

## Revendications

1. Dispositif onduleur (42) comportant au moins un circuit de conversion direct (47) pour obtenir un courant-continu à partir d'un courant-alternatif, un circuit de conversion inverse (48) pour convertir un courant-continu en un courant-alternatif, un condensateur de lissage (6), une plaque à bornes d'entrée (2A) et une plaque à bornes de sortie (2B), dans lequel

   au moins ledit circuit de conversion direct (47) et ledit circuit de conversion inverse (48) sont disposés sur une surface d'un substrat de forme sensiblement rectangulaire, et des pluralités d'éléments formant bornes sont disposées sur ledit substrat, **caractérisé en ce que** ledit substrat est un substrat métallique, lesdites pluralités d'éléments formant bornes sont disposées à des extrémités opposées dudit substrat métallique de sorte que ladite plaque à bornes d'entrée (2A) est formée à la première extrémité dudit substrat métallique et ladite plaque à bornes de sortie (2B) est formée à l'autre extrémité dudit substrat métallique pour constituer ainsi une unité intégrée à plaques à bornes formant circuit principal (2), et ledit circuit de conversion direct (47) et ledit circuit de conversion inverse (48), ainsi que lesdits éléments formant bornes, sont moulés de manière à former une seule et même structure.

2. Dispositif onduleur (42) selon la revendication 1, dans lequel ledit substrat métallique dudit module intégré à plaques à bornes formant circuit principal (2) est monté sur une unité à ailettes de refroidissement (1), et un substrat de circuit (3) encapsulé avec un circuit de commande pour commander ledit circuit de conversion inverse (48) et un substrat de circuit (8) encapsulé avec un condensateur (6) pour lisser une tension de sortie courant-continu dudit circuit de conversion direct (47) et un module logique pour générer des signaux de commande pour ledit circuit de commande sont séquentiellement empilés sur la surface dudit substrat métallique à l'opposé de ladite unité à ailettes de refroidissement (1).

3. Dispositif onduleur (42) selon la revendication 2, dans lequel ladite plaque à bornes d'entrée est équipée de bornes (P, N) reliées à un bus courant-continu de circuit principal, et dans lequel des fils de connexion (15) s'étendent à partir desdites bornes jusqu'audit condensateur (6).

4. Dispositif onduleur (42) selon la revendication 1, **caractérisé en ce que** ledit dispositif onduleur comporte en outre une structure de châssis (5) de forme creuse similaire à celle d'une boîte formée dans une partie d'un carter dudit dispositif onduleur, une chambre de réception de condensateur (12) formée à l'intérieur de ladite structure de châssis, et des bornes de connexion pouvant être montées et enlevées élastiquement, et **en ce que** le montage mécanique dudit condensateur (6) sur ledit dispositif onduleur (42) est réalisé en insérant ledit condensateur (6) dans ladite chambre de réception de condensateur (12), tandis que la connexion électrique audit condensateur (6) est réalisée en insérant lesdites bornes de connexion (15A ou 25) dans des bornes d'électrode (6A) dudit condensateur (6).

5. Dispositif onduleur (42) selon la revendication 4, **caractérisé en ce que** ladite chambre de réception de condensateur (12) est formée dans une paroi à l'intérieur de ladite structure de châssis (5), **en ce qu'**une ouverture est formée dans une paroi disposée à l'opposé de ladite première paroi, et **en ce qu'**un élément (7) recouvrant ladite ouverture est monté d'une manière amovible à partir de l'extérieur de ladite structure de châssis (5).

6. Dispositif onduleur (42) selon la revendication 4, **caractérisé en ce que** lesdites bornes de connexion (15A ou 25) sont reliées à un circuit principal de l'onduleur par l'intermédiaire de fils isolés (15) ou de barres conductrices (23).

7. Dispositif onduleur (42) selon la revendication 4, **caractérisé en ce que** lesdites bornes de connexion (25) sont agencées à l'intérieur de ladite chambre de réception de condensateur (12), et **en ce que**, lorsque ledit condensateur (6) est inséré dans ladite chambre de réception de condensateur (12), lesdites bornes d'électrode dudit condensateur (6) sont amenées en contact avec lesdites bornes de connexion (25) pour établir ainsi ladite connexion électrique.

8. Dispositif onduleur (42) selon la revendication 4, **caractérisé en ce que** ladite chambre de réception de condensateur (12) a au moins deux gorges (12A, 12B) formées séquentiellement dedans au niveau de positions différentes tel que vu dans la direction dans laquelle ledit condensateur est inséré, et **en ce qu'**un élément de positionnement de condensateur (36) est adapté d'une manière sélective dans l'une desdites gorges.

F I G. 1

F I G. 2

# F I G. 3A

# F I G. 3B

# F I G. 3C

# F I G. 3D

# F I G. 4

EP 0 688 092 B1

FIG. 5A

FIG. 5B

FIG. 5C

# FIG. 6

EP 0 688 092 B1

# F I G. 7

# F I G. 8

FIG. 9

FIG. 10

# F I G. 11

# F I G. 12

FIG. 13A

180
330
470
560

12A
12

FIG. 13B

36

FIG. 13C

36

12A

12

# F I G. 14A

47

R(LI)

S

T(N)

+

6

48

# F I G. 14B

47

R(LI)

T(N)

+

6

48

# F I G. 14C

47

R(LI)

T(N)

+

6

+

6

48

FIG. 15A

FIG. 15B

FIG. 15C

F I G. 16

# FIG. 17A

# FIG. 17B

EP 0 688 092 B1

F I G. 18A

58    59    2B    2A    59    58

F I G. 18B

58    53    59 60 2B    63    2A 60   59    53    58
                                      62

EP 0 688 092 B1

FIG. 19C

FIG. 19A

FIG. 19B

55

64

58

64

64

58

58

55

58

EP 0 688 092 B1

36

# F I G. 20A

# F I G. 20B